# EUROPEAN PATENT SPECIFICATION

(11) **EP 2 873 300 B1**
(45) Date of publication and mention of the grant of the patent: **01.05.2019**
(21) Application number: 13729606.7
(22) Date of filing: 14.06.2013
(51) Int. Cl.: H05B 33/20, H01L 51/00

(54) **ORGANIC ELECTRONIC DEVICE COMPRISING AN ORGANIC SEMICONDUCTOR FORMULATION**
ORGANISCHE ELEKTRONISCHE VORRICHTUNG MIT EINEM ORGANISCHEN HALBLEITERMATERIAL
DISPOSITIF ÉLECTRONIQUE ORGANIQUE COMPRENANT UNE FORMULATION DE SEMI-CONDUCTEUR ORGANIQUE

(30) Priority: 13.07.2012 EP 12005161
(43) Date of publication of application: 20.05.2015
(73) Proprietor: Merck Patent GmbH, 64293 Darmstadt (DE)
(72) Inventor: TAN, Li Wei, CHANDLERS FORD SO53 2AZ (GB); BHINTADE, Rashmi, WINCHESTER SO21 1NG (GB); WIERZCHOWIEC, Piotr, 69118 HEIDELBERG (DE); WANG, Changsheng, EASTLEIGH SO53 3GW (GB); BLOUIN, Nicolas, 64295 DARMSTADT (DE)
(86) International application number: PCT/EP2013/001769
(87) International publication number: WO 2014/008971

(56) References cited:
- EP-A2- 1 670 079
- EP-A2- 2 020 693
- WO-A1-2011/128035
- KWON JAE-HONG ET AL: "Organic thin film transistors using 6,13-bis(tri-isopropylsilylethynyl)pentace ne embedded into polymer binders", APPLIED PHYSICS LETTERS, AIP, AMERICAN INSTITUTE OF PHYSICS, MELVILLE, NY, US, vol. 94, no. 1, 8 January 2009 (2009-01-08), pages 13506-13506, XP012118255, ISSN: 0003-6951, DOI: 10.1063/1.3063123
- TSUYOSHI SEKITANI ET AL: "Printed Organic Transistors for Ultraflexible and Stretchable Electronics", ECTC 2011: CPMT SEMINAR PRINTED DEVICES AND LARGE AREA INTERCONNECT TECHNOLOGIES FOR NEW ELECTRONICS, 1 January 2011 (2011-01-01), pages 1-34, XP55075073,

## Description

### Technical Field

The invention generally relates to organic semiconductor layers in organic electronic devices, and more specifically in organic field effect transistors, and to organic electronic devices and organic field effect transistors encompassing such organic semiconductor layers.

### Background

In recent years there has been growing interest in organic electronic (OE) devices, for example organic field effect transistors (OFET) for use in backplanes of display devices or logic capable circuits, and organic photovoltaic (OPV) devices. A conventional OFET comprises a gate electrode, a gate insulator layer made of a dielectric material (also referred to as "dielectric" or "gate dielectric"), source and drain electrodes, a semiconducting layer made of an organic semiconductor (OSC) material, and often a passivation layer on top of the aforementioned layers to protect them against environmental influence and/or against damage from subsequent device manufacturing steps.

For OFET devices solution processable OSC layers are especially desired. The OSC materials should be solution based and should be suitable for solution based deposition methods like spin-coating, slot-die coating and doctor blade coating, or wider area printing methods such as flexo, gravure, and screen printing. Key requirements for OSC materials used in such solution processed layers are orthogonality of the OSC solvent towards the underlying layer, and good adhesion of the OSC to the underlying layer and to the layer deposited on top of the OSC layer.

Polymeric binders are commonly used with solution processed OSCs to increase performance of Organic Field Effect Transistors (OFET), as disclosed for example in J. Mater. Chem., 2008, 18, 3230-3236, or Appl. Phys. Lett., 2009, 94, 013506 - 013506-3, or to increase processability of the OSC formulation, as disclosed for example in US 2004/0038459 A1 or WO 2005/055248 A2.

EP 1 670 079 A2 discloses the use of Parylene as dielectric in thin film transistors.

However, OSC formulations containing the commonly used polymeric binders, such as polystyrene, poly(4-methylstyrene), poly(α-methylstyrene), poly(4-vinylbiphenyl) for example, have some drawbacks in certain applications, like for example weak adhesion to available top coatings such as gate dielectrics or passivation layers.

Currently some of the most commonly used top gate dielectrics for OFETs are materials having low permittivity (also known as relative permittivity or dielectric constant) of less than 3.0 ("low k material"). The use of such low k materials is reported to reduce charge trapping at the dielectric/OSC interface and to give improved transistor performance, as disclosed for example in Adv. Funct. Mat., 2003, 13, 199-204, or in US 7,029,945 B2.

Typical examples of low k dielectrics, which are orthogonal to many OSCs are the following:
1) Solution processable fluorinated materials, like those of the Teflon AF™ (DuPont) or Cytop™ (AGJ) series, as disclosed for example in US 2011/0037064 A1 or in Adv. Mat., 2009, 21, 1166-1171,
2) Chemical vapor deposited poly(p-xylylene), also known as "Parylene", as disclosed for example in Appl. Phys. Lett., 2008, 93, 183305 1-3.

In addition, in order to improve the mechanical integrity within the stack of layers present in OE devices, for example in bottom gate OFET devices, passivation layers are commonly applied on top of OSC. The passivation layers have to meet the same orthogonality and adhesion requirements as the above mentioned dielectric layers in top gate configuration.

Parylene (poly(p-xylylene) is a dielectric material that is often used in the dielectric or passivation layers of OE devices including OFETs. Parylene is a commercially available dielectric which polymerizes when being deposited on a substrate from a vaporized p-xylylene monomer. The advantage of Parylene is its relatively simple processing, resulting in a highly pure and homogeneous thin film, which is an excellent chemical barrier, both thermally stable and UV stable.

However, the adhesion of Parylene to the commonly used binder/OSC compositions, and also to many commonly available polymers which are typically used as binders, like those listed above is often very low, in many cases lower than 0.05N, but typically below detection level.

Therefore, it is desired to have available OSC compositions that show improved adhesion to Parylene layers used as dielectric or passivation layers in OE devices. The adhesion should preferably be at least 0.5 N.

One aim of the present invention is to provide materials for use in OSC layers which meet these requirements. Another aim is to provide improved OE devices, in particular OFETs, comprising such improved OSC layers and dielectric or passivation layers comprising Parylene. Another aim is to provide improved methods of manufacturing such OSC layers. Further aims are immediately evident to the person skilled in the art from the following description.

The inventors have found these aims can be achieved by providing an OE device comprising an OSC layer that comprises an OSC and adhesion promoter, which improves the adhesion of the OSC to Parylene, while enabling good OE device performance.

### Summary

The invention relates to an organic electronic (OE) device comprising
- an organic semiconducting (OSC) layer comprising an organic semiconductor and an organic binder,
- an electrode and
- a dielectric layer located between said OSC layer and said electrode, characterized in that
- the dielectric layer comprises polymerized p-xylylene that is optionally substituted, and
- the organic binder comprises a compound comprising one or more divalent units selected from formula 1, 2 and 3 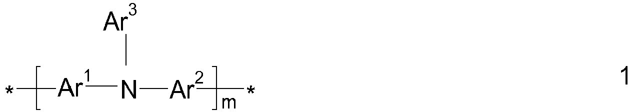 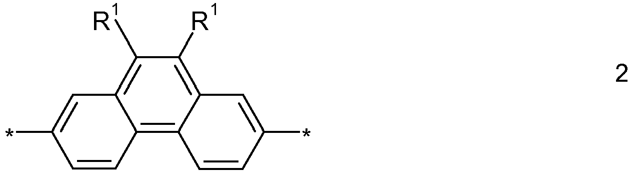 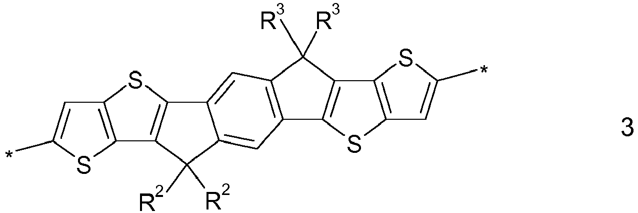 wherein
   - Ar¹, Ar² and Ar³: denote, independently of each other and on each occurrence identically or differently, an optionally substituted mononuclear or polynuclear aryl or heteroaryl group, Ar¹ may also denote a single bond, and Ar³ may also have one of the meanings of R¹,
   - m: is 1, 2 or 3,
   - R¹, R² and R³: independently of each other, and on each occurrence identically or differently, denote H, F, Cl, Br, CN, straight-chain, branched or cyclic alkyl, with 1 to 30 C atoms, in which one or more non-adjacent C atoms are optionally replaced by -O-, -S-, -C(O)-, -C(O)-O-, -O-C(O)-, -O-C(O)-O-, -C(S)-, -C(S)-O-, -O-C(S)-, -O-C(S)-O-, -C(O)-S-, -S-C(O)-, -O-C(O)-S-, -S-C(O)-O-, -S-C(O)-S-, -S-C(S)-S-,-O-C(S)-S-, -S-C(S)-O-, -C(S)-S-, -S-C(S)-, -NR⁰-,-SiR⁰R⁰⁰-, -CY¹=CY²- or -C≡C- in such a manner that O and/or S atoms are not linked directly to one another, and in which one or more H atoms are optionally replaced by F, Cl, Br, I or CN, or R¹ and R², independently of each other, and on each occurrence identically or differently, denote aryl, heteroaryl, aryloxy or heteroaryloxy with 4 to 20 ring atoms which is optionally substituted, or R¹ and R² together form an alicyclic group with 1 to 20 C atoms, which is optionally fluorinated or alkylated,
   - Y¹ and Y²: are independently of each other H, F, Cl or CN,
   - R⁰ and R⁰⁰: are independently of each other H or optionally substituted C₁₋₄₀ carbyl or hydrocarbyl, and preferably denote H or alkyl with 1 to 12 C-atoms.

The invention further relates to an OSC formulation comprising an OSC and an organic binder, and a solvent, wherein the organic binder includes a compound comprising one or more divalent units selected from formula 1, 2 and 3.

The invention further relates to an OSC layer being obtained through the use of an OSC formulation as described above and below, to a process of preparing such an OSC layer, and to an OE device comprising such an OSC layer.

The invention further relates to an OE device, an OSC formulation or an OSC layer as described above and below, wherein the OSC comprises an optionally substituted oligoacene or optionally substituted heteroacene. The invention further relates to a process of preparing an OE device in accordance with the invention.

The OE device is for example an Organic Field Effect Transistor (OFET), including Organic Thin Film Transistor (OTFT) as a particular case, an Organic Light Emitting Diode (OLED), an Organic Photovoltaic (OPV) device or Organic Photodetector (OPD), preferably an OFET, very preferably a top gate OFET.

The invention further relates to a product or an assembly comprising an OE device as described above and below. Such product or assembly is preferably an Integrated Circuit (IC), a Radio Frequency Identification (RFID) tag, a security marking or security device containing an RFID tag, a Flat Panel Display (FPD), a backplane of an FPD, a backlight of an FPD, an electrophotographic device, an electrophotographic recording device, an organic memory device, a pressure sensor, an optical sensor, a chemical sensor, a biosensor or a biochip.

### Brief Description of the Drawings

Embodiments of the invention are described below with reference to the following drawings.
**Figure 1** is a schematic representation of a top gate OFET device in accordance with the present invention.
**Figure 2** is a schematic representation of a bottom gate OFET device in accordance with the present invention.
**Figure 3, 4****,** **5** and **6** depict the transistor characteristic of a top gate OFET device that are prepared in accordance with Example 1, 2, 3 and 4, respectively.

### Detailed Description

As used herein, the term "Organic Field Effect Transistors (OFETs)" will be understood to be inclusive of the subclass of such devices known as "Organic Thin Film Transistors (OTFTs)".

In addition, it will be understood that the terms "dielectric" and "insulating" are used interchangeably herein. Thus reference to an insulating material or layer is inclusive of a dielectric material or layer. Further, as used herein, the term "organic electronic device" will be understood to be inclusive of the term "organic semiconductor device" and the several specific implementations of such devices such as the OFETs as defined above.

The terms "Parylene" and "poly(p-xylylene)" are used interchangeably herein, thus reference to Parylene is inclusive of a poly(p-xylylene) and vice versa, and "poly(p-xylylene)" denotes a polymerized p-xylylene that is optionally substituted. Parylene is the generic tradename for a series of chemical vapor deposited poly(p-xylylenes). Parylene is usually prepared by chemical vapor deposition of a p-xylylene intermediate of the following structure 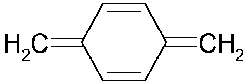 which is optionally substituted as described below. The p-xylyene intermediate can be derived from [2.2]paracyclophane of the following structure

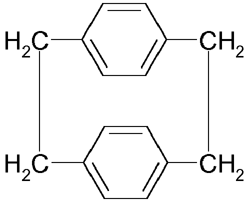

The phenylene rings and/or the methylene groups of the p-xylylene repeating units in the polymers may also be substituted. The polymers may also comprise two or more distinct types of unsubstituted and/or substituted p-xylylene repeating units. For example, Parylene N denotes unsubstituted poly(p-xylylene) of the following structure 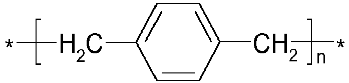 while Parylene C and Parlyene D denote mono- or dichlorinated poly(p-xylylene) of the following structure, respectively

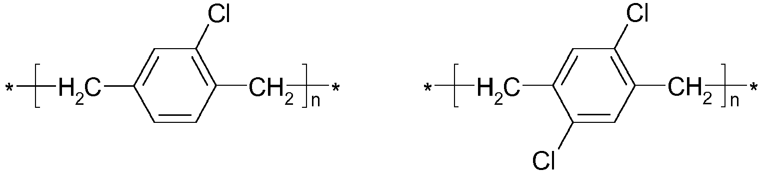

Further Parylene types include for example those wherein the phenylene or methylene groups are fluorinated, like Parylene AF-4, Parylene SF, or Parylene HT all comprising difluorinated methylene groups, or Parylene VT comprising a fluorinated phenylene. Further Parylene types include reactive co-polymers comprising unsubstituted p-xylylene units (as in Parylene N) and p-xylylene units wherein the phenylene ring is substituted by a reactive or crosslinkable group, for example by an amine (Parylene A), a methylamine (Parylene AM), or an ethynyl group (Parylene X).

Unless stated otherwise, the terms "Parylene" and "poly(p-xylylene)" as used hereinafter, will be understood to include both unsubstituted and substituted Parylene types, including but not limited to Parylene N, C, D, AF-4, SF, HT, VT, A, AM, X etc.

As used herein, the terms "orthogonal" and "orthogonality" will be understood to mean chemical orthogonality. For example, an orthogonal solvent means a solvent which, when used in the deposition of a layer of a material dissolved therein on a previously deposited layer, does not dissolve said previously deposited layer.

As used herein, the term "polymer" will be understood to mean a molecule that encompasses a backbone of one or more distinct types of repeating units (the smallest constitutional unit of the molecule) and is inclusive of the commonly known terms "oligomer", "copolymer", "homopolymer" and the like. Further, it will be understood that the term polymer is inclusive of, in addition to the polymer itself, residues from initiators, catalysts and other elements attendant to the synthesis of such a polymer, where such residues are understood as not being covalently incorporated thereto. Further, such residues and other elements, while normally removed during post polymerization purification processes, are typically mixed or co-mingled with the polymer such that they generally remain with the polymer when it is transferred between vessels or between solvents or dispersion media.

As used herein, the term "small molecule" will be understood to mean a monomeric or oligomeric compound which typically does not contain a reactive group by which it can be reacted to form a polymer, and which is designated to be used in monomeric or oligomeric form. In contrast thereto, the term "monomer" unless stated otherwise will be understood to mean a monomeric compound that carries one or more reactive functional groups by which it can be reacted to form a polymer.

As used herein, the term "organic semiconductor (OSC) formulation", also shortly referred to as "formulation", means at least one organic semiconductor (OSC) compound and one or more other materials added to the at least one OSC compound to provide, or to modify, specific properties of the OSC formulation and or the at least one OSC compound therein. It will be understood that an OSC formulation is also a vehicle for carrying the OSC to a substrate to enable the forming of layers or structures thereon. Exemplary materials include, but are not limited to, solvents, volatile surfactants and adhesion promoters.

As used herein, the term "conjugated" will be understood to mean a compound (for example a small molecule or a polymer) that contains mainly C atoms with sp²-hybridisation (or optionally also sp-hybridisation), and wherein these C atoms may also be replaced by hetero atoms. In the simplest case this is for example a compound with alternating C-C single and double (or triple) bonds, but is also inclusive of compounds with aromatic units like for example 1,4-phenylene. The term "mainly" in this connection will be understood to mean that a compound with naturally (spontaneously) occurring defects, which may lead to interruption of the conjugation, is still regarded as a conjugated compound.

As used herein, the term "carbyl group" will be understood to mean denotes any monovalent or multivalent organic radical moiety which comprises at least one carbon atom either without any non-carbon atoms (like for example -C≡C-), or optionally combined with at least one non-carbon atom such as N, O, S, P, Si, Se, As, Te or Ge (for example carbonyl etc.). The term "hydrocarbyl group" will be understood to mean a carbyl group that does additionally contain one or more H atoms and optionally contains one or more hetero atoms like for example N, O, S, P, Si, Se, As, Te or Ge.

As used herein, the term "hetero atom" will be understood to mean an atom in an organic compound that is not a H- or C-atom, and preferably will be understood to mean N, O, S, P, Si, Se, As, Te or Ge.

A carbyl or hydrocarbyl group comprising a chain of 3 or more C atoms may be straight-chain, branched and/or cyclic, including spiro and/or fused rings.

Preferred carbyl and hydrocarbyl groups include alkyl, alkoxy, alkylcarbonyl, alkoxycarbonyl, alkylcarbonyloxy and alkoxycarbonyloxy, each of which is optionally substituted and has 1 to 40, preferably 1 to 25, very preferably 1 to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms, wherein all these groups do optionally contain one or more hetero atoms, preferably selected from N, O, S, P, Si, Se, As, Te and Ge.

The carbyl or hydrocarbyl group may be a saturated or unsaturated acyclic group, or a saturated or unsaturated cyclic group. Unsaturated acyclic or cyclic groups are preferred, especially aryl, alkenyl and alkynyl groups (especially ethynyl). Where the C₁-C₄₀ carbyl or hydrocarbyl group is acyclic, the group may be straight-chain or branched. The C₁-C₄₀ carbyl or hydrocarbyl group includes for example: a C₁-C₄₀ alkyl group, a C₁-C₄₀ alkoxy or oxaalkyl group, a C₂-C₄₀ alkenyl group, a C₂-C₄₀ alkynyl group, a C₃-C₄₀ allyl group, a C₄-C₄₀ alkyldienyl group, a C₄-C₄₀ polyenyl group, a C₆-C₁₈ aryl group, a C₆-C₄₀ alkylaryl group, a C₆-C₄₀ arylalkyl group, a C₄-C₄₀ cycloalkyl group, a C₄-C₄₀ cycloalkenyl group, and the like. Preferred among the foregoing groups are a C₁-C₂₀ alkyl group, a C₂-C₂₀ alkenyl group, a C₂-C₂₀ alkynyl group, a C₃-C₂₀ allyl group, a C₄-C₂₀ alkyldienyl group, a C₆-C₁₂ aryl group, and a C₄-C₂₀ polyenyl group, respectively. Also included are combinations of groups having carbon atoms and groups having hetero atoms, like e.g. an alkynyl group, preferably ethynyl, that is substituted with a silyl group, preferably a trialkylsilyl group.

The terms "aryl" and "heteroaryl" as used herein preferably mean a mono-, bi- or tricyclic aromatic or heteroaromatic group with 4 to 30 ring C atoms that may also comprise condensed rings and is optionally substituted with one or more groups L,
wherein L is selected from halogen, -CN, -NC, -NCO, -NCS, -OCN, -SCN, -C(=O)NR⁰R⁰⁰, -C(=O)X⁰, -C(=O)R⁰, -NH₂, -NR⁰R⁰⁰, -SH, -SR⁰, -SO₃H,-SO₂R⁰, -OH, -NO₂, -CF₃, -SF₅, P-Sp-, optionally substituted silyl, or carbyl or hydrocarbyl with 1 to 40 C atoms that is optionally substituted and optionally comprises one or more hetero atoms, and is preferably alkyl, alkoxy, thiaalkyl, alkylcarbonyl, alkoxycarbonyl or alkoxycarbonyloxy with 1 to 20 C atoms that is optionally fluorinated, and R⁰, R⁰⁰, X⁰, P and Sp have the meanings given above and below.

Very preferred substituents L are selected from halogen, most preferably F, or alkyl, alkoxy, oxaalkyl, thioalkyl, fluoroalkyl and fluoroalkoxy with 1 to 12 C atoms or alkenyl, alkynyl with 2 to 12 C atoms.

Especially preferred aryl and heteroaryl groups are phenyl in which, in addition, one or more CH groups may be replaced by N, naphthalene, thiophene, selenophene, thienothiophene, dithienothiophene, fluorene and oxazole, all of which can be unsubstituted, mono- or polysubstituted with L as defined above. Very preferred rings are selected from pyrrole, preferably N-pyrrole, furan, pyridine, preferably 2- or 3-pyridine, pyrimidine, pyridazine, pyrazine, triazole, tetrazole, pyrazole, imidazole, isothiazole, thiazole, thiadiazole, isoxazole, oxazole, oxadiazole, thiophene preferably 2-thiophene, selenophene, preferably 2-selenophene, thieno[3,2-b]thiophene, indole, isoindole, benzofuran, benzothiophene, benzodithiophene, quinole, 2- methylquinole, isoquinole, quinoxaline, quinazoline, benzotriazole, benzimidazole, benzothiazole, benzisothiazole, benzisoxazole, benzoxadiazole, benzoxazole, benzothiadiazole, all of which can be unsubstituted, mono- or polysubstituted with L as defined above. Further examples of heteroaryl groups are those selected from the formulae as shown hereinafter.

An alkyl or alkoxy radical, i.e. where the terminal CH₂ group is replaced by -O-, can be straight-chain or branched. It is preferably straight-chain, has 2, 3, 4, 5, 6, 7 or 8 carbon atoms and accordingly is preferably ethyl, propyl, butyl, pentyl, hexyl, heptyl, octyl, ethoxy, propoxy, butoxy, pentoxy, hexoxy, heptoxy, or octoxy, furthermore methyl, nonyl, decyl, undecyl, dodecyl, tridecyl, tetradecyl, pentadecyl, nonoxy, decoxy, undecoxy, dodecoxy, tridecoxy or tetradecoxy, for example.

An alkenyl group, wherein one or more CH₂ groups are replaced by - CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are C₂-C₇-1E-alkenyl, C₄-C₇-3E-alkenyl, C₅-C₇-4-alkenyl, C₆-C₇-5-alkenyl and C₇-6-alkenyl, in particular C₂-C₇-1E-alkenyl, C₄-C₇-3E-alkenyl and C₅-C₇-4-alkenyl. Examples for particularly preferred alkenyl groups are vinyl, 1E-propenyl, 1E-butenyl, 1E-pentenyl, 1E-hexenyl, 1E-heptenyl, 3-butenyl, 3E-pentenyl, 3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, i.e. where one CH₂ group is replaced by -O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.Oxaalkyl, i.e. where one CH₂ group is replaced by - O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one CH₂ group is replaced by -O- and one by - C(O)-, these radicals are preferably neighboured. Accordingly these radicals together form a carbonyloxy group -C(O)-O- or an oxycarbonyl group -O-C(O)-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxy-ethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonyl methyl, ethoxycarbonylmethyl, propoxycarbonylmethyl, butoxycarbonylmethyl, 2-(methoxycarbonyl)ethyl, 2-(ethoxycarbonyl)ethyl, 2-(propoxycarbonyl)ethyl, 3-(methoxycarbonyl)propyl, 3-(ethoxycarbonyl)propyl, 4-(methoxycarbonyl)-butyl.

An alkyl group wherein two or more CH₂ groups are replaced by -O- and/or -C(O)O- can be straight-chain or branched. It is preferably straight-chain and has 3 to 12 C atoms. Accordingly it is preferably bis-carboxymethyl, 2,2-bis-carboxy-ethyl, 3,3-bis-carboxy-propyl, 4,4-bis-carboxybutyl, 5,5-bis-carboxy-pentyl, 6,6-bis-carboxy-hexyl, 7,7-bis-carboxyheptyl, 8,8-bis-carboxy-octyl, 9,9-bis-carboxy-nonyl, 10,10-bis-carboxydecyl, bis-(methoxycarbonyl)-methyl, 2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxycarbonyl)-methyl, 2,2-bis-(ethoxycarbonyl)-ethyl, 3,3-bis-(ethoxycarbonyl)-propyl, 4,4-bis-(ethoxycarbonyl)-butyl, 5,5-bis-(ethoxycarbonyl)-hexyl.

A thioalkyl group, i.e where one CH₂ group is replaced by -S-, is preferably straight-chain thiomethyl (-SCH₃), 1-thioethyl (-SCH₂CH₃), 1-thiopropyl (= -SCH₂CH₂CH₃), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the CH₂ group adjacent to the sp² hybridised vinyl carbon atom is replaced.

A fluoroalkyl group is preferably perfluoroalkyl CᵢF₂ᵢ₊₁, wherein i is an integer from 1 to 15, in particular CF3, C2F5, C3F7, C₄F₉, C5F11, C6F13, C₇F₁₅ or C₈F₁₇, very preferably C₆F₁₃, or partially fluorinated alkyl, in particular 1,1-difluoroalkyl, all of which are straight-chain or branched.

Alkyl, alkoxy, alkenyl, oxaalkyl, thioalkyl, carbonyl and carbonyloxy groups can be achiral or chiral groups. Particularly preferred chiral groups are 2-butyl (=1-methylpropyl), 2-methylbutyl, 2-methylpentyl, 3-methylpentyl, 2-ethylhexyl, 2-propylpentyl, in particular 2-methylbutyl, 2-methylbutoxy, 2-methylpentoxy, 3-methylpentoxy, 2-ethyl-hexoxy, 1-methylhexoxy, 2-octyloxy, 2-oxa-3-methylbutyl, 3-oxa-4-methyl-pentyl, 4-methylhexyl, 2-hexyl, 2-octyl, 2-nonyl, 2-decyl, 2-dodecyl, 6-meth-oxyoctoxy, 6-methyloctoxy, 6-methyloctanoyloxy, 5-methylheptyloxy-carbonyl, 2-methylbutyryloxy, 3-methylvaleroyloxy, 4-methylhexanoyloxy, 2-chloropropionyloxy, 2-chloro-3-methylbutyryloxy, 2-chloro-4-methyl-valeryl-oxy, 2-chloro-3-methylvaleryloxy, 2-methyl-3-oxapentyl, 2-methyl-3-oxahexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl, 2-fluoromethyloctyloxy for example. Very preferred are 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tert. butyl, isopropoxy, 2-methyl-propoxy and 3-methylbutoxy.

In a preferred embodiment of the present invention, R¹⁻³ are independently of each other selected from primary, secondary or tertiary alkyl or alkoxy with 1 to 30 C atoms, wherein one or more H atoms are optionally replaced by F, or aryl, aryloxy, heteroaryl or heteroaryloxy that is optionally alkylated or alkoxylated and has 4 to 30 ring atoms. Very preferred groups of this type are selected from the group consisting of the following formulae 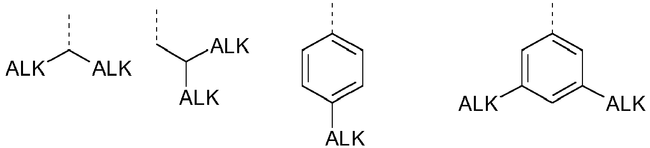 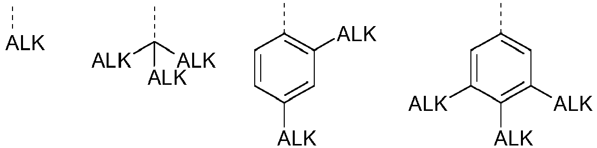 wherein "ALK" denotes optionally fluorinated, preferably linear, alkyl or alkoxy with 1 to 20, preferably 1 to 12 C-atoms, in case of tertiary groups very preferably 1 to 9 C atoms, and the dashed line denotes the link to the ring to which these groups are attached. Especially preferred among these groups are those wherein all ALK subgroups are identical.
-CY¹¹=CY¹²- is preferably -CH=CH-, -CF=CF- or -CH=C(CN)-.

As used herein, "halogen" includes F, CI, Br or I, preferably F, CI or Br.

A used herein, -CO-, -C(=O)- and -C(O)- will be understood to mean a carbonyl group, i.e. a group having the structure

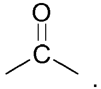

As mentioned above, the adhesion of Parylene to typical binder/OSC compositions as used in prior art, especially the adhesion of Parylene to commonly available polymers which are typically used as binders, was found to be very low, often below 0.05N, but typically below detection level. For example, poly(9,9-dioctylfluorene) was found to have a typical adhesion value to Parylene C of <0.2N.

The present invention provides a way of improving the adhesion of an OSC layer to a dielectric layer of Parylene in an OE device, without sacrificing the processing parameters and device performance.

This is achieved by using an OSC formulation in accordance with the present invention, which comprises an organic binder (hereinafter also shortly referred to as "binder") that also acts as adhesion promoter to the Parylene dielectric layer.

The binder is preferably selected from compounds having an adhesion to ParyleneC of ≥0.5N/inch, preferably of ≥ 1N/inch, very preferably of ≥ 2N/inch.

The binder comprises, and preferably consists of, one or more compounds comprising one or more divalent units selected from formula 1, 2 and 3 as described above and below.

The binder can either be an additional component of the OSCs formulation, thus replacing commonly used organic binders such as polystyrene, poly-alpha methyl styrene etc. Alternatively the binder can be chemically bonded to the OSC. The binder can be a dielectric material or a semiconducting material.

The binder contains one or more units of formula 1, 2 and/or 3, which were shown to have good adhesion to Parylene. These units can also be varied for example by attaching solubilising groups R¹⁻³ to improve processability.

The binder can be a small molecule, including monomers and oligomers, a polymer, or a co-polymer.

In a first preferred embodiment of the present invention, the binder is selected from compounds comprising one or more divalent repeating units of formula 1 (triarylamine, diaryl tertiary amine or N,N-diarylamide). These compounds can be small molecules, including monomers and oligomers, containing a unit of formula 1, or polymers containing one or more units of formula 1, or co-polymers containing one or more units of formula 1 and one or more additional units.

Preferred small molecules comprising a unit of formula 1 are selected from formula M1 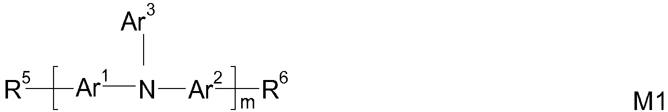 wherein Ar¹⁻³ and m are as defined in formula 1, and R⁵ and R⁶, which may be the same or different, are selected from H, halogen, silyl, substituted or unsubstituted aryl or heteroaryl having from 3 to 20 C atoms, alkyl, alkoxy, alkylthio, alkylcarbonyl, alkoxycarbonyl, alkylcarbonyloxy, each having from 1 to 20 C atoms, or cycloalkyl, arylalkyl, aryloxy or arylthio, each having from 3 to 20 C atoms.

Examples of suitable and preferred small molecules include, without limitation, those of the following formula:

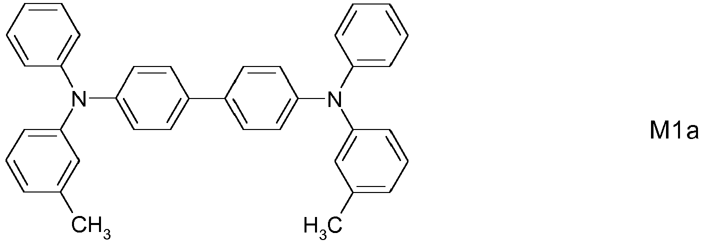

Preferred polymers comprising a unit of formula 1 are those comprising a unit selected from the following subformulae: 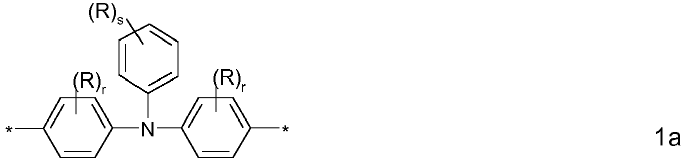 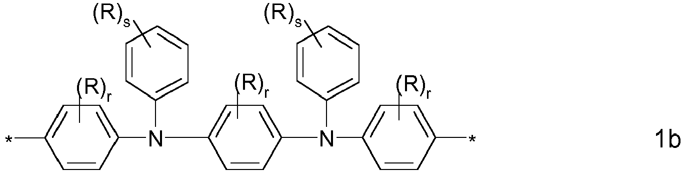 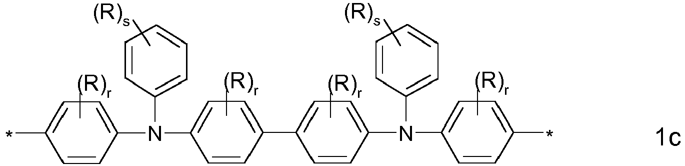 wherein R has one of the meanings of R¹ as given in formula 2, r is 0, 1, 2, 3 or 4, and s is 0, 1, 2, 3, 4 or 5.

Very preferred polymers comprising a unit of formula 1 include, without limitation, those of the following formulae: 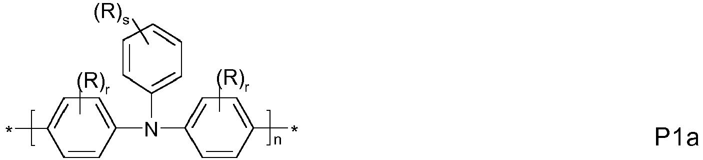 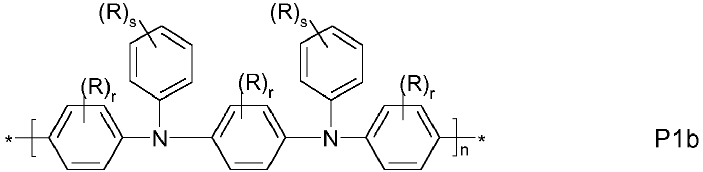 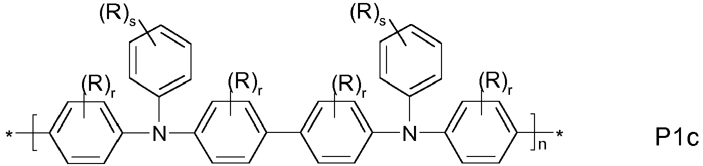 wherein R, r and s are as defined in formula 1a and n is an integer >1.

The polymers comprising a unit of formula 1 are preferably endcapped, preferably by H atoms or phenyl groups that are optionally alkylated.

Examples of suitable and preferred polymers of formula P1a include, without limitation, those of the following formulae: 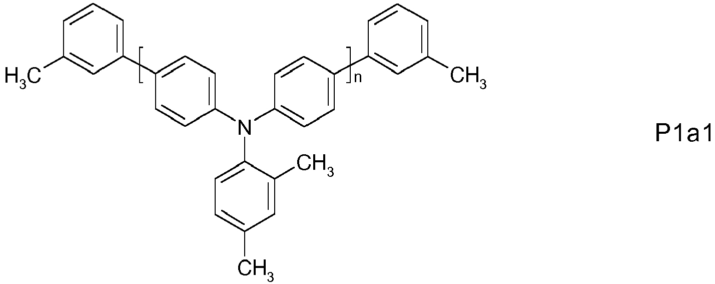 wherein n is an integer >1.

Preferred co-polymers comprise one or more units of formula 1 or its subformulae 1a-c, and one or more additional units selected from arylene and heteroarylene units that are optionally substituted, preferably by L as described above. Very preferred co-polymers are selected from the following formulae: 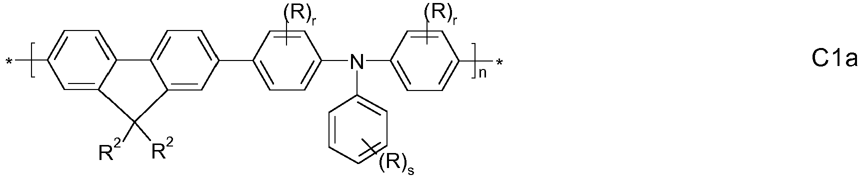 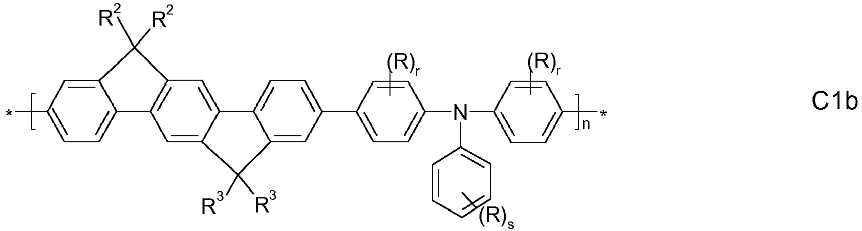 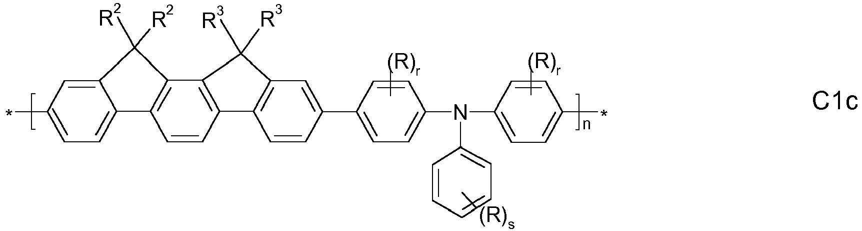 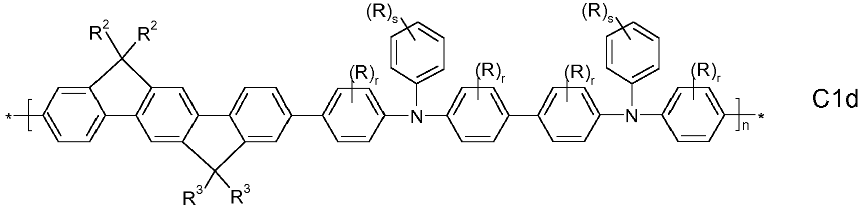 wherein R² and R³ are as defined in formula 3, and R, r, s and n are as defined in formula P1a.

Examples of suitable and preferred co-polymers of formula C1a-d include, without limitation, those of the following formulae: 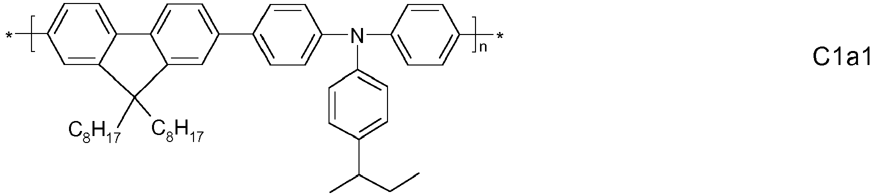 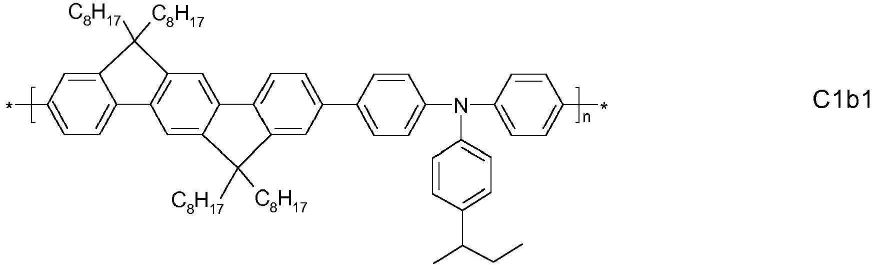 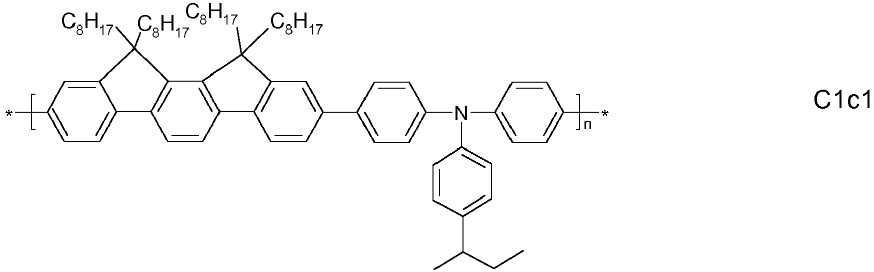 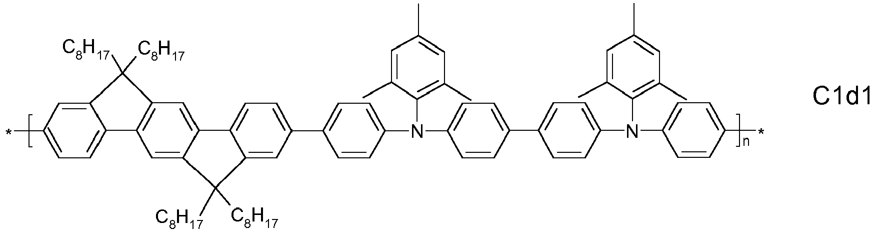 wherein n is an integer >1.

In a second preferred embodiment of the present invention, the binder is selected from compounds comprising one or more divalent repeating units of formula 2 (phenanthrene), wherein these compounds are preferably polymers, very preferably co-polymers comprising one or more units of formula 2 and one or more co-units.

Preferably said co-units are selected from arylene and heteroarylene units that are optionally substituted, preferably by L as described above.

In a third preferred embodiment of the present invention, the binder is selected from compounds comprising one or more divalent repeating units of formula 3 (dithieno[2,3-d:2',3'-d']-s-indaceno[1,2-b:5,6-b']dithiophene, hereinafter also referred to as "IDTT"), wherein these compounds are homopolymers or co-polymers comprising one or more units of formula 3 and optionally one or more co-units.

Preferably said co-units are selected from arylene and heteroarylene units that are optionally substituted, preferably by L as described above.

Preferred polymers comprising a unit of formula 3 are selected from the following formula: 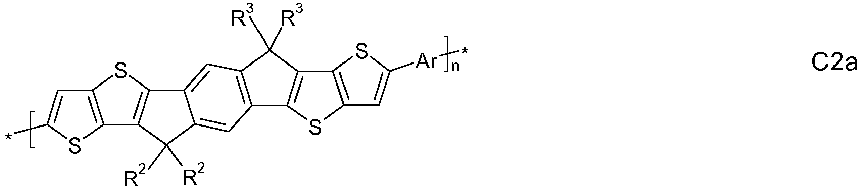 wherein R² and R³ are as defined in formula 3, R, r, s and n are as defined in formula P1a, and Ar has one of the meanings of Ar¹ in formula 1.

Preferably Ar is selected from the group consisting of thiophene-2,5-diyl, thieno[2,3-b]thiophene-2,5-diyl, thieno[3,2-b]thiophene-2,5-diyl, and selenophene-2,5-diyl, all of which are optionally substituted by one or more groups L as defined above.

In another preferred embodiment Ar is a single bond.

Examples of suitable and preferred polymers of formula C2a include, without limitation, those of the following formulae: 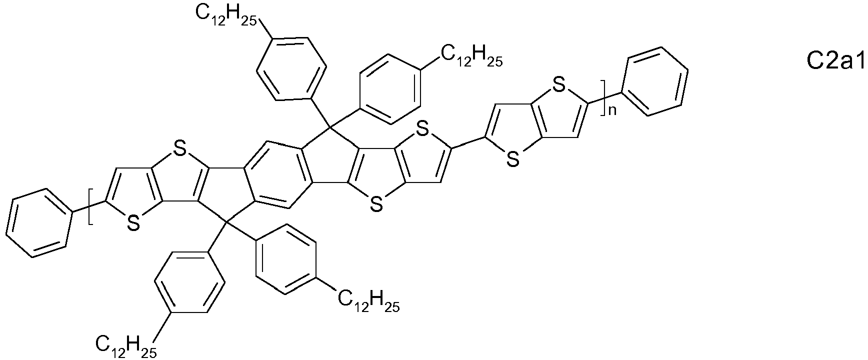 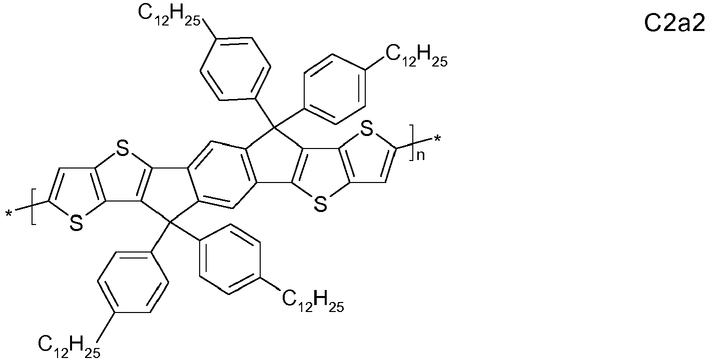 wherein n is an integer >1.

In a fourth preferred embodiment of the present invention, the binder is selected from co-polymers comprising one or more repeating units selected from one of formulae 1, 2 and 3, and one or more repeating units selected from another one of formulae 1, 2 and 3.

For example, the co-polymer according to said fourth preferred embodiment comprises a first repeating unit of formula 1 and a second repeating unit of formula 2, or the co-polymer comprises a first repeating unit of formula 1 and a second repeating unit of formula 3, or the co-polymer comprises a first repeating unit of formula 2 and a second repeating unit of formula 3, or the co-polymer comprises a first repeating unit of formula 1, a second repeating unit of formula 2, and a third repeating unit of formula 3.

Preferred co-polymers according to said fourth preferred are selected from the following formulae: 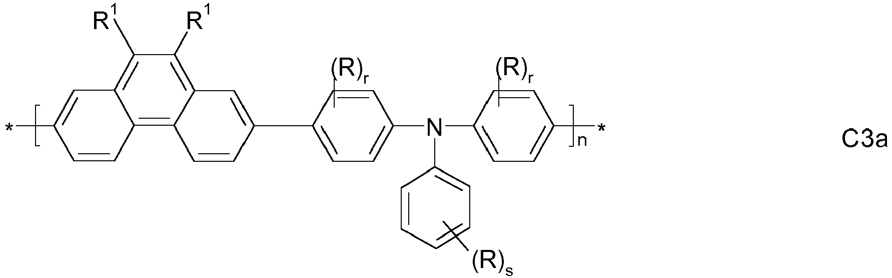 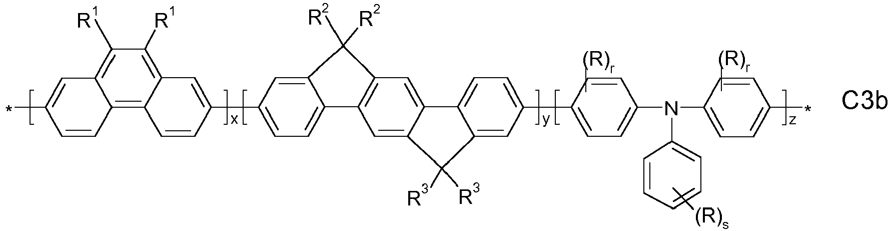 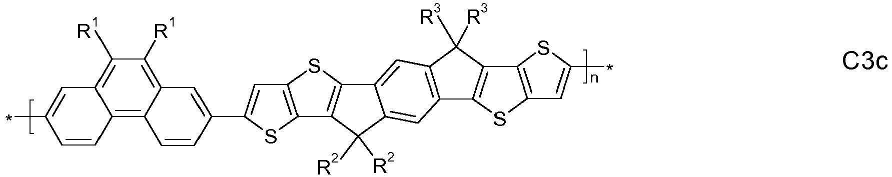 wherein R¹ is as defined in formula 2, R² and R³ are as defined in formula 3, R, r, s and n are as defined in formula P1a, and x, y and z denote the mole fraction of the respective unit in the co-polymer, and x, y and z are each >0 and <1.

Preferably in the co-polymer of formula C3b x+y+z=1.

Examples of suitable and preferred co-polymers of formula C3a-c include, without limitation, those of the following formulae: 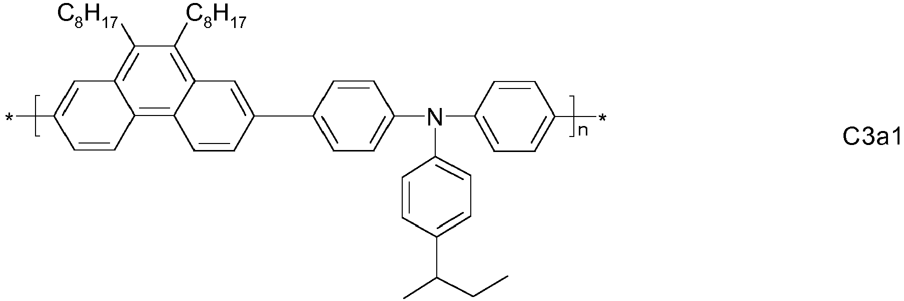 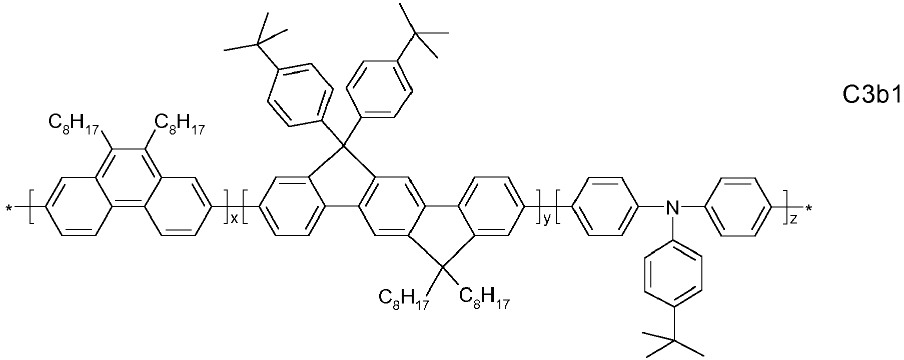 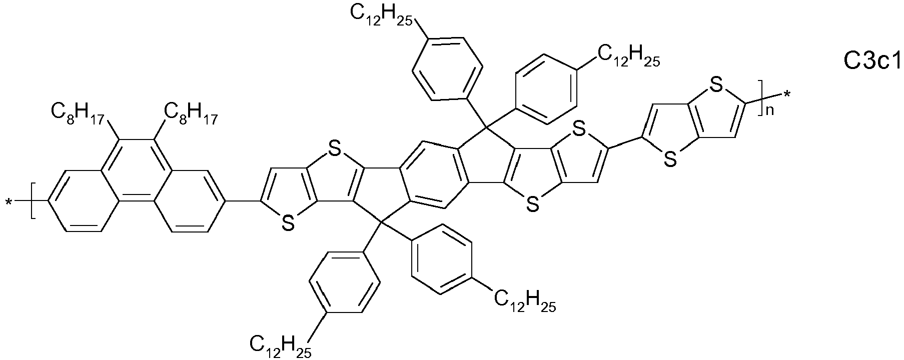 wherein n is an integer >1. In the co-polymer of formula C3b1 preferably x=0.35, y=0.5 and z=0.15.

In the units of formula 1, 2 or 3 and the small molecules, polymers and co-polymers comprising them as described above and below, R is preferably alkyl with 1 to 5 C atoms, and R² and R³ preferably denote, independently of each other, straight-chain or branched alkyl with 1 to 20 C atoms, or aryl with 5 to 12 C atoms, very preferably phenyl, that is optionally substituted with C₁₋₁₂ alkyl or C₁₋₁₂ alkoxy. In another preferred embodiment one of R² and R³ is straight-chain or branched alkyl with 1 to 20 C atoms and the other of R² and R³ is aryl with 5 to 12 C atoms, very preferably phenyl, that is optionally substituted with C1-12 alkyl or C1-12 alkoxy.

The polymers and co-polymers comprising a unit of formula 1, 2 or 3 as described above and below are preferably encapped. Preferred endcap groups are H, C1-20 alkyl, or optionally substituted C6-12 aryl or C₂₋₁₀ heteroaryl, very preferably H or phenyl that is optionally substituted with one or more C1-12 alkyl or C1-12 alkoxy groups.

The organic semiconductor (OSC) can be an n- or p- type OSC. Effective OSCs exhibit a FET mobility of greater than 1x10⁻⁵ cm²V⁻¹s⁻¹.

The OSC can be a small molecule, a polymer or a co-polymer, including mixtures, dispersions and blends of one or more of small molecules, polymers or co-polymers.

Small molecule OSCs are advantageous as they can be deposited by a thermal evaporation process, and easily purified by multiple sublimation process. Small molecule OSCs can also be modified to be soluble in organic solvents for deposition by a solution process like coating or printing. Polymeric OSCs are advantageous as they can be modified, for example by changing the molecular weight in order to improve the viscosity and/or by adding solubilising substituents in order to improve solubility, which is especially important when using printing processes, or by varying the co-units in order to change the HOMO-LUMO level and thus optimize charge carrier mobility.

In a preferred embodiment of the present invention, the OSC is a small molecule.

In a further preferred embodiment the OSC formulation comprises, in addition to the OSC and the organic binder, respectively, a casting or printing solvent.

Suitable and preferred solvents include, without limitation, cyclohexylbenzene, mesitylene, indan, xylene, tetraline, ethyl benzene, methyl naphthalene, anisole, alkyl benzene, cumene, cyclohexanone, ethyl benzoate, toluene, cineole, and any combinations of the aforementioned solvents.

The concentration of the OSC in the formulation is preferably from 0.1 to 5%, very preferably from 0.5 to 2%.

The concentration of the organic binder in the formulation is preferably from 0.1 to 5%, very preferably from 0.5 to 2%.

The aforementioned concentration values refer to the formulation comprising the solvent(s) and all solid components, like OSC, organic binder etc.

For OSC formulations comprising a small molecule OSC, the proportion of the organic binder to the OSC in the formulation is preferably from 1:99 to 99:1, very preferably from 10:90 to 90:10.

Preferably the OSC formulation contains an organic binder, an OSC and a solvent at a ratio binder:OSC:solvent of 0.5 to 2.0:0.5 to 2.0:96 to 99 (wt.%).

The OSC used in the OSC formulations and OE devices in accordance with the present invention can be any conjugated molecule, for example an aromatic molecule containing preferably two or more, very preferably at least three aromatic rings. In some preferred embodiments of the present invention, the OSC contains aromatic rings selected from 5-, 6- or 7-membered aromatic rings, while in other preferred embodiments the OSC contains aromatic rings selected from 5- or 6-membered aromatic rings.

Each of the aromatic rings of the OSC optionally contains one or more hetero atoms selected from Se, Te, P, Si, B, As, N, O or S, generally from N, O or S. Further, the aromatic rings may be optionally substituted with fluoro, cyano, alkyl, alkoxy, polyalkoxy, thioalkyl, silyl, ethynylsilyl, optionally substituted secondary or tertiary alkylamine or arylamine, aryl or substituted aryl groups, wherein ethynylsilyl groups are represented by -C≡C-SiR'R"R''', and substituted secondary or tertiary alkylamine or arylamine are represented by -N(R')(R"), wherein R' and R" are each independently H, optionally fluorinated C₁₋₁₂ alkyl or optionally fluorinated C₆₋₁₀ aryl.

The aforementioned aromatic rings can be fused rings or linked with a conjugated linking group such as -C(T')=C(T")-, -C≡C-, -N(R"")-,-N=N-, (R"")=N-, -N=C(R"")-, where T'and T" each independently represent H, CI, F, -C≡N or lower alkyl groups such as C₁₋₄ alkyl groups and R"" is as defined above.

In a preferred embodiments of the present invention, the OSC includes small molecules and derivatives thereof selected from the group consisting of condensed aromatic hydrocarbons such as, tetracene, chrysene, pentacene, pyrene, perylene, coronene, or soluble substituted and/or heterocylic derivatives of the aforementioned; oligomeric para substituted phenylenes such as p-quaterphenyl (p-4P), p-quinquephenyl (p-5P), p-sexiphenyl (p-6P) or soluble substituted derivatives of these; benzidine compounds; stilbene compounds; triazines; substituted metallo- or metal-free porphines, phthalocyanines, fluorophthalocyanines, naphthalocyanines or fluoronaphthalocyanines; C₆₀ and C₇₀ fullerenes; *N,N'*-dialkyl, substituted dialkyl, diaryl or substituted diaryl-1,4,5,8-naphthalenetetracarboxylic diimide and fluoro derivatives; *N,N'*-dialkyl, substituted dialkyl, diaryl or substituted diaryl 3,4,9,10-perylenetetracarboxylicdiimide; bathophenanthroline; diphenoquinones; 1,3,4-oxadiazoles; 11,11,12,12-tetracyanonaptho-2,6-quinodimethane; α,α'-bis(dithieno[3,2-b2',3'-d]thiophene); 2,8-dialkyl, substituted dialkyl, diaryl or substituted diaryl anthradithiophene; 2,2'-bibenzo[1,2-b:4,5-b']dithiophene. Where a liquid deposition technique of the OSC is desired, compounds from the above list and derivatives thereof are limited to those that are soluble in an appropriate solvent or mixture of appropriate solvents.

In another preferred embodiment of the present invention, the OSC is selected from the group consisting of substituted oligoacenes such as pentacene, tetracene or anthracene, or heterocyclic derivatives thereof. Bis(trialkylsilylethynyl) oligoacenes or bis(trialkylsilylethynyl) heteroacenes, for example fluorinated bis(trialkylsilylethynyl) anthradithiophenes, as disclosed for example in US 6,690,029, WO 2005/055248 A1 or US 7,385,221, are especially preferred.

In another preferred embodiment of the present invention, the OSC is selected from organic semiconducting polymers, including conjugated hydrocarbon polymers such as polyacene, polyphenylene, poly(phenylene vinylene), polyfluorene; and conjugated heterocyclic polymers such as poly(3-substituted thiophene), poly(3,4-bisubstituted thiophene), optionally substituted polythieno[2,3-b]thiophene, optionally substituted polythieno[3,2-b]thiophene, poly(3-substituted selenophene), polybenzothiophene, polyisothianapthene, poly(*N*-substituted pyrrole), poly(3-substituted pyrrole), poly(3,4-bisubstituted pyrrole), polyfuran, polypyridine, poly-1,3,4-oxadiazoles, polyisothianaphthene, poly(*N*-substituted aniline), poly(2-substituted aniline), poly(3-substituted aniline), poly(2,3-bisubstituted aniline), polyazulene, polypyrene; pyrazoline compounds; polyselenophene; polybenzofuran; polyindole; polypyridazine.

Further, in another preferred embodiment in accordance with the present invention, the OSC is selected from polymers or co-polymers that encompass one or more repeating units selected from thiophene-2,5-diyl, 3-substituted thiophene-2,5-diyl, optionally substituted thieno[2,3-b]thiophene-2,5-diyl, optionally substituted thieno[3,2-b]thiophene-2,5-diyl, selenophene-2,5-diyl, or 3-substituted selenophene-2,5-diyl.

Further preferred p-type OSCs are co-polymers comprising electron acceptor and electron donor units. Preferred co-polymers of this preferred embodiment are for example copolymers comprising one or more benzo[1,2-b:4,5-b']dithiophene-2,5-diyl units that are preferably 4,8-disubstituted by one or more groups R as defined above, and further comprising one or more aryl or heteroaryl units selected from Group A and Group B, preferably comprising at least one unit of Group A and at least one unit of Group B, wherein Group A consists of aryl or heteroaryl groups having electron donor properties and Group B consists of aryl or heteroaryl groups having electron acceptor properties, and preferably

Group A consists of selenophene-2,5-diyl, thiophene-2,5-diyl, thieno[3,2-b]thiophene-2,5-diyl, thieno[2,3-b]thiophene-2,5-diyl, selenopheno[3,2-b]selenophene-2,5-diyl, selenopheno[2,3-b]selenophene-2,5-diyl, selenopheno[3,2-b]thiophene-2,5-diyl, selenopheno[2,3-b]thiophene-2,5-diyl, benzo[1,2-b:4,5-b']dithiophene-2,6-diyl, 2,2-dithiophene, 2,2-diselenophene, dithieno[3,2-*b*:2',3'-*d*]silole-5,5-diyl, 4*H*-cyclopenta[2,1-*b*:3,4-*b'*]dithiophene-2,6-diyl, 2,7-di-thien-2-yl-carbazole, 2,7-di-thien-2-yl-fluorene, indaceno[1,2-b:5,6-b']dithiophene-2,7-diyl, benzo[1",2":4,5;4",5":4',5']bis(silolo[3,2-b:3',2'-b']thiophene)-2,7-diyl, 2,7-di-thien-2-yl-indaceno[1,2-b:5,6-b']dithiophene, 2,7-di-thien-2-yl-benzo[1",2":4,5;4",5":4',5']bis(silolo[3,2-b:3',2'-b']thiophene)-2,7-diyl, and 2,7-di-thien-2-yl-phenanthro[1,10,9,8-*c,d,e,f,g*]carbazole, all of which are optionally substituted by one or more, preferably one or two groups R as defined above, and

Group B consists of benzo[2,1,3]thiadiazole-4,7-diyl, 5,6-dialkyl-benzo[2,1,3]thiadiazole-4,7-diyl, 5,6-dialkoxybenzo[2,1,3]thiadiazole-4,7-diyl, benzo[2,1,3]selenadiazole-4,7-diyl, 5,6-dialkoxy-benzo[2,1,3]selenadiazole-4,7-diyl, benzo[1,2,5]thiadiazole-4,7,diyl, benzo[1,2,5]selenadiazole-4,7,diyl, benzo[2,1,3]oxadiazole-4,7-diyl, 5,6-dialkoxybenzo[2,1,3]oxadiazole-4,7-diyl, 2H-benzotriazole-4,7-diyl, 2,3-dicyano-1,4-phenylene, 2,5-dicyano,1,4-phenylene, 2,3-difluro-1,4-phenylene, 2,5-difluoro-1,4-phenylene, 2,3,5,6-tetrafluoro-1,4-phenylene, 3,4-difluorothiophene-2,5-diyl, thieno[3,4-b]pyrazine-2,5-diyl, quinoxaline-5,8-diyl, thieno[3,4-b]thiophene-4,6-diyl, thieno[3,4-b]thiophene-6,4-diyl, and 3,6- pyrrolo[3,4-c]pyrrole-1,4-dione, all of which are optionally substituted by one or more, preferably one or two groups R as defined above.

OSC embodiments in accordance with the present invention are especially suitable for use in OFETs where the OSC is used as the active channel material. OSCs for such embodiments can be deposited by any of the previously discussed deposition methods, but as they are generally deposited or formed as blanket layers, solvent coated methods such as spray-, dip-, web- or spin-coating, doctor blade, bar and slot-die coating or printing methods such as ink-jet printing, flexo printing, gravure printing, or screen printing are typically employed to allow for ambient temperature processing.

In preferred embodiments in accordance with the present invention, deposition and/or forming of the OSC layer are performed using solution processing techniques. For example a formulation or composition of the OSC material and the polymeric additive, typically a solution encompassing one or more organic solvents, can be deposited or formed using preferred techniques that include, but are not limited to, dip coating, slot-die coating spin coating, ink jet printing, letter-press printing, screen printing, doctor blade coating, bar coating, roller printing, reverse-roller printing, offset lithography printing, flexographic printing, web printing, spray coating, brush coating, or pad printing, followed by the evaporation of the solvent employed to form such a solution. For example, an organic semiconductor material, a bank structure material and an organic dielectric material can each be deposited or formed by spin coating, flexographic printing, and inkjet printing techniques in an order appropriate to the device being formed.

Suitable process conditions for the vapor deposition process of forming the Parylene layer are known to the skilled person and are described in the literature, for example in P. Kramer et al., Journal of Polymer Science: Polymer Chemistry Edition, Vol. 22 (1984), pp. 475-491 .

Another embodiment of the present invention relates to an OSC layer obtained through the use of a formulation in accordance with the invention.

Another embodiment of the present invention relates to a process of preparing an OSC layer, comprising the steps of depositing a formulation in accordance with the invention onto a substrate and removing the solvent.

Another embodiment of the present invention relates to an OE device comprising an OSC layer and a dielectric layer, wherein the OSC layer is obtained through the use of a formulation in accordance with the invention, and the dielectric layer comprises a poly(p-xylylene).

Another embodiment of the present invention relates to a process of preparing an OE device as described above and below, comprising the steps of
a) depositing an OSC formulation as described above and below onto a substrate to form an OSC layer,
b) removing the solvent,
c) optionally annealing the OSC layer,
d) depositing a layer of a p-xylylene onto the OSC layer by vapour deposition.

The formulation according to the present invention can be used for preparing OSC layers of OE devices. The OE devices include, among others, organic field effect transistors (OFETs), including organic thin film transistors (OTFTs) as a particular type of OFET, which can be top gate or bottom gate transistors, Organic Light Emitting Diodes (OLED), Organic Photodetector (OPD) or Organic Photovoltaic (OPV) Devices.

In a preferred embodiment of the present invention the OE device is a top gate OFET comprising a gate dielectric layer comprising a poly(p-xylylene).

In another preferred embodiment of the present invention the OE device is a bottom gate OFET comprising a passivation layer comprising a poly(p-xylylene).

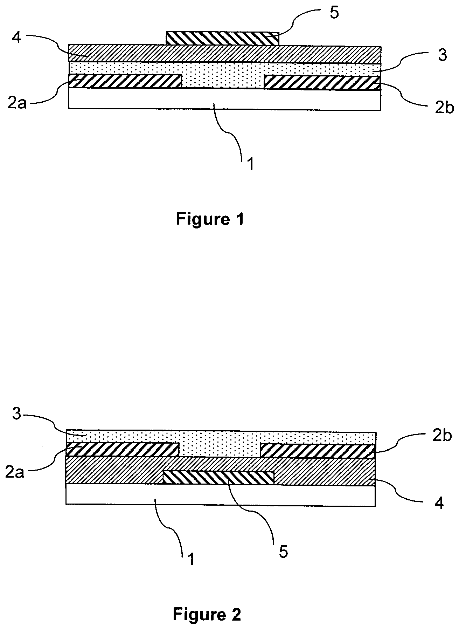

A top gate OFET in accordance with the present invention is depicted schematically in **Figure 1****,** and a bottom gate OFET in accordance with the present invention is depicted schematically in **Figure 2****.**

Turning now to **Figure 1****,** a schematic and simplified representation of a top gate OFET device in accordance with a preferred embodiment of the present invention is provided. Such OFET device includes a substrate (1), source and drain electrodes (2a, 2b), an OSC layer (3) obtained through the use of an OSC formulation as described above and below, a dielectric layer (4) comprising a poly(p-xylylene) and serving as gate insulator, and a gate electrode (5).

Another embodiment of the present invention relates to a process for preparing a top gate OFET device, for example as illustrated in **Figure 1****,** by a process comprising the steps of
A) forming source and drain electrodes (2a,2b) on a substrate (1),
B) forming an OSC layer (3) from a formulation in accordance with the invention on the source and drain electrodes (2a,2b),
C) forming a dielectric layer (4) by vapor deposition of a p-xylyene on the OSC layer (3),
D) forming a gate electrode (5) on the dielectric layer (4).

Turning now to **Figure 2****,** a schematic and simplified representation of a bottom gate OFET device in accordance with a preferred embodiment of the present invention is provided. Such OFET device includes a substrate (1), a gate electrode (5), a dielectric layer (4) comprising a poly(p-xylylene) and serving as gate insulator, source and drain electrodes (2a, 2b), and an OSC layer (3) obtained through the use of an OSC formulation as described above and below.

Another embodiment of the present invention relates to a process for preparing a bottom gate OFET device, for example as illustrated in **Figure 2****,** by a process comprising the steps of
A) forming a gate electrode (5) on a substrate (1),
B) forming a dielectric layer (4) by vapor deposition of a p-xylyene on the the substrate (1) and the gate electrode (5),
C) forming source and drain electrodes (2a,2b) on the dielectric layer (4).
D) forming an OSC layer (3) from a formulation in accordance with the invention on the source and drain electrodes (2a,2b) and the dielectric layer (4).

The electrodes (2a, 2b, 5) are for example applied onto the substrate (1) or the dielectric layer (4) by a printing or a sputtering process, and can be patterned by etching and/or lithographic patterning. The OSC layer (3) and dielectric layer (4) can be applied by a coating or printing process as described above.

Apart of the components described above, the OFET devices shown in **Figure 1** and **2** may contain further layers or structures that are not shown, like for example passsivation layers, planarization layers or bank structures.

The other components or functional layers of the electronic device, like the substrate and the gate, source and drain electrodes, can be selected from standard materials, and can be manufactured and applied to the device by standard methods. Suitable materials and manufacturing methods for these components and layers are known to a person skilled in the art and are described in the literature. Exemplary deposition methods include the liquid coating methods previously described as well as chemical vapor deposition (CVD) or physical vapor deposition methodologies.

Generally the thickness of a functional layer, for example a gate dielectric or OSC layer, in some preferred electronic device embodiments according to the present invention is from 0.001 (in case of a monolayer) to 10 µm; In other preferred embodiments such thickness ranges from 0.001 to 1 µm, and in still other preferred embodiments from 5 nm to 500 nm, although other thicknesses or ranges of thickness are contemplated and thus are within the scope of the present invention.

Various substrates may be used for the fabrication of the electronic device embodiments of the present invention. For example glass or polymeric materials are most often used. Preferred polymeric materials include, but are not limited to, alkyd resins, allyl esters, benzocyclobutenes, butadiene-styrene, cellulose, cellulose acetate, epoxide, epoxy polymers, ethylene-chlorotrifluoro ethylene copolymers, ethylene-tetra-fluoroethylene copolymers, fiber glass enhanced plastic, fluorocarbon polymers, hexafluoropropylene-vinylidene-fluoride copolymer, high density polyethylene, parylene, polyamide, polyimide, polyaramid, polydimethylsiloxane, polyethersulphone, poly-ethylene, polyethylenenaphthalate, polyethyleneterephthalate, polyketone, polymethylmethacrylate, polypropylene, polystyrene, polysulphone, polytetrafluoroethylene, polyurethanes, polyvinylchloride, polycycloolefin, silicone rubbers, and silicones, where polyethyleneterephthalate, polyimide, polycycloolefin and polyethylenenaphthalate materials have been found most appropriate. Additionally, for some embodiments of the present invention the substrate can be any suitable material, for example plastic, metal or glass material coated with one or more of the above listed materials or with any other insulating layers. It will be understood that in forming such a substrate, methods such as extruding, stretching, rubbing or photochemical techniques can be employed to provide a homogeneous surface for device fabrication as well as to provide pre-alignment of an organic semiconductor material in order to enhance carrier mobility therein.

The gate, source and drain electrodes of the OFET device embodiments in accordance with the present invention can be deposited or formed by liquid coating, such as spray-, dip-, web- or spin-coating, or by vacuum deposition methods including but not limited to physical vapor deposition (PVD), chemical vapor deposition (CVD) or thermal evaporation methods. Suitable electrode materials and deposition methods are known to the person skilled in the art. Suitable electrode materials include, without limitation, inorganic or organic materials, or composites of the two. Exemplary electrode materials include polyaniline, polypyrrole, poly(3,4-ethylenedioxy-thiophene) (PEDOT) or doped conjugated polymers, further dispersions or pastes of graphite or particles of metal such as Au, Ag, Cu, Al, Ni or their mixtures as well as sputter coated or evaporated metals such as Cu, Cr, Pt/Pd, Ag, Au or metal oxides such as indium tin oxide (ITO) F-doped ITO or Al-doped ZnO. Organometallic precursors may also be used and deposited from a liquid phase.

Unless the context clearly indicates otherwise, as used herein plural forms of the terms herein are to be construed as including the singular form and vice versa.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the features of the invention are applicable to all aspects of the invention and may be used in any combination. Likewise, features described in non-essential combinations may be used separately (not in combination).

The invention will now be described in more detail by reference to the following examples, which are illustrative only and do not limit the scope of the invention.

Above and below, unless stated otherwise percentages are per cent by weight and temperatures are given in degrees Celsius (°C).

The adhesion values (in N/inch), unless stated otherwise, are measured by the peel test method as described in Example 1.

### Example 1

For various organic binder compounds according to the invention and according to prior art the adhesion to Parylene was measured by a 90° peel test as follows.

To determine the binder adhesion to parylene, a formulation consisting of 2% binder in mesitylene is prepared. A piece of 2 inch square glass substrate is pre-cleaned with methanol rinsing and spin dried. The binder formulation is deposited on the glass substrate by spin coating at 1500rpm for30s. The binder layer is dried by annealed at 100°C for 2 min on top of the hotplate. Then the sample is transferred to the Parylene coater.

During the Parylene deposition, the first step is vaporization of the solid Parylene dimer at approximately 150° C. The second step is the quantitative cleavage (pyrolysis) of the dimer at the two methylene-methylene bonds at about 680° C to yield the stable monomeric diradical, para-xylylene. Finally, the monomer enters the room temperature deposition chamber where it simultaneously adsorbs and polymerizes on the substrate. No liquid phase has been isolated and the substrate temperature never rises more than a few degrees above ambient.

After the Parylene deposition, the sample is transferred to the 90 degree peel test to determine the adhesion strength.

If the binder has very low adhesion to glass, the Parylene layer can be deposited on top of the glass, and then the binder is spin coated on top of the Parylene layer in order to determine the peel strength of the Parylene/binder interface.

A 90° peel test is performed by applying a tension load to the material interface under test. An adhesive tape (of suitable tack) is applied to the top surface of the interface and held at a 90°angle by a clamp connected to a load cell.

The system is programmed to (i) First adjust the slack between tape and test sample to roughly 90°C (ii) Move the test platform at a preset speed whilst peeling the tape off the substrate.

The platform motion maintains the tape perpendicular to the test sample.The resultant force required to peel off the top layer is recorded as a function of distance in the software, and is plotted as peel strength vs. distance.

The results are summarized in Table 1 below.

**Table 1**

| Compound | Adhesion [N/inch] |
|---|---|
| 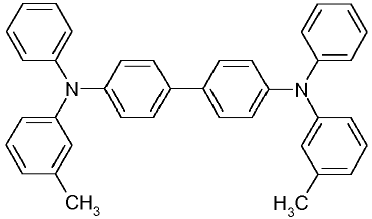 | 16 |
| 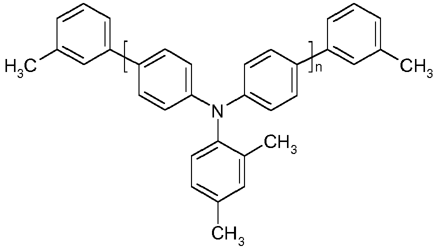 | 6 |
| M_{w} = (29,000) | |
| 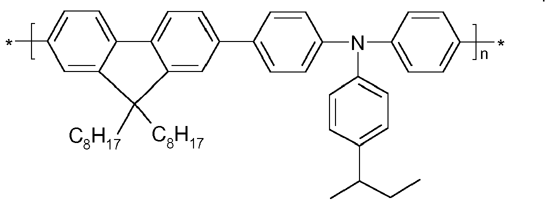 | 2 |
| 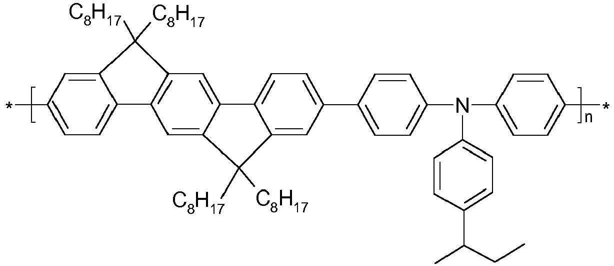 | 2 |
| 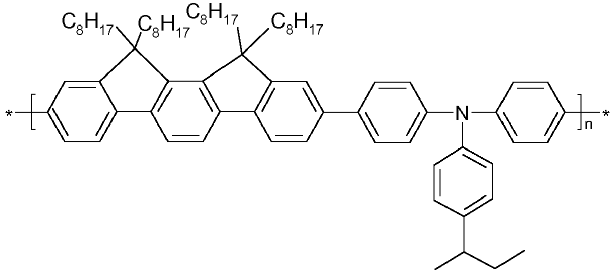 | |
| 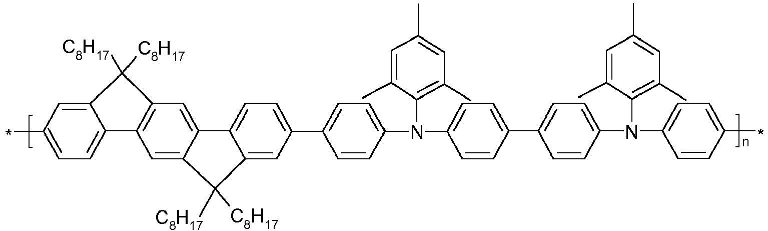 | |
| 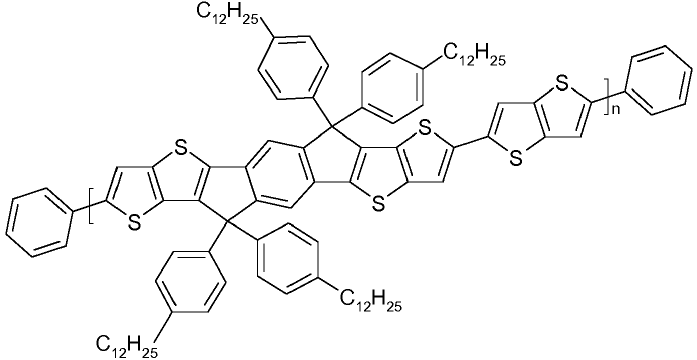 | 4-6 |
| 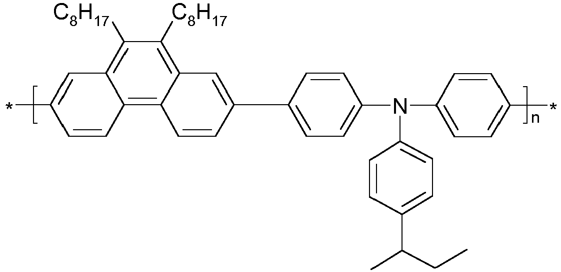 | >20* |
| 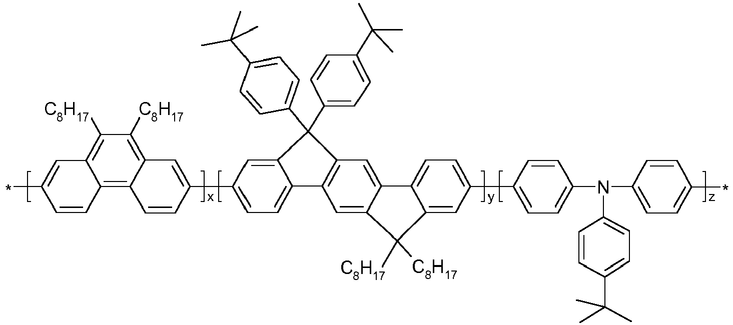 | |
| 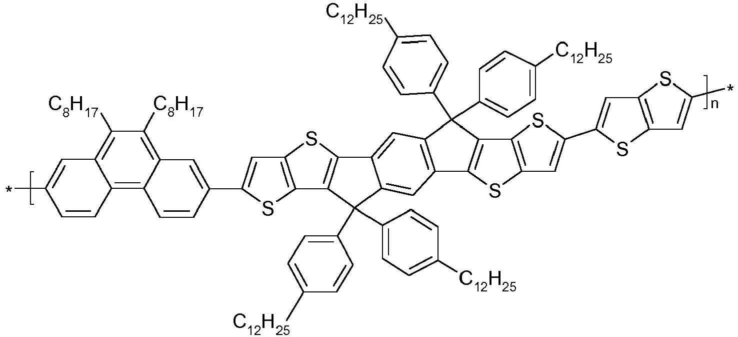 | 7.5 |
| 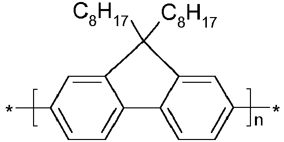 | 0.1N |

| | |
|---|---|
| * above measurement instrument limit | |

All materials according to the invention show a good adhesion to Parylene of at least 2 N/inch or higher.

### Example 2

An OSC formulation is prepared as follows:
Poly(tetraoctyl indeno fluorene-alt-triarylamine) (Formula C1a1) as organic binder is mixed with 2,8-Difluoro-5,11-bis(triethylsilylethynyl) anthradithiophene as OSC and dissolved in cyclohexylbenzene at a ratio binder:OSC:solvent of 1.34:0.66:98, so that the ratio binder:OSC is 2:1.

The adhesion of the OSC formulation to Parylene C is 1.8N, measured by a 90° peel test.

A top gate OFET device is prepared as follows.

A substrate glass is precleaned with 5% Decon-90 in aqeous for 30 min at 70°C followed by DI water rinsing for 5 times, ultrasonic treatment in DI water for 5 min, followed by methanol rinsing for 5 min and spin drying.

Source-drain gold electrodes (40nm thickness) are formed by shadow deposition of Au using thermal evaporation technique. An SAM of perfluorobenzene thiol is deposited on the substrate with the S-D electrodes for 1 min to improve work function of gold electrode. The SAM layer is spin dried and annealed for 2 min at 100°C before the OSC coating.

The OSC formulation is spin coated at 1500rpm for 60s and annealed on a hotplate at 100°C for 2 min.

Subsequently, an 800nm layer of Parylene C is deposited by chemical vapour deposition on top of OSC layer, to form the gate dielectric layer.

Finally, a 40nm layer of gold gate electrode is deposited by thermal evaporation.

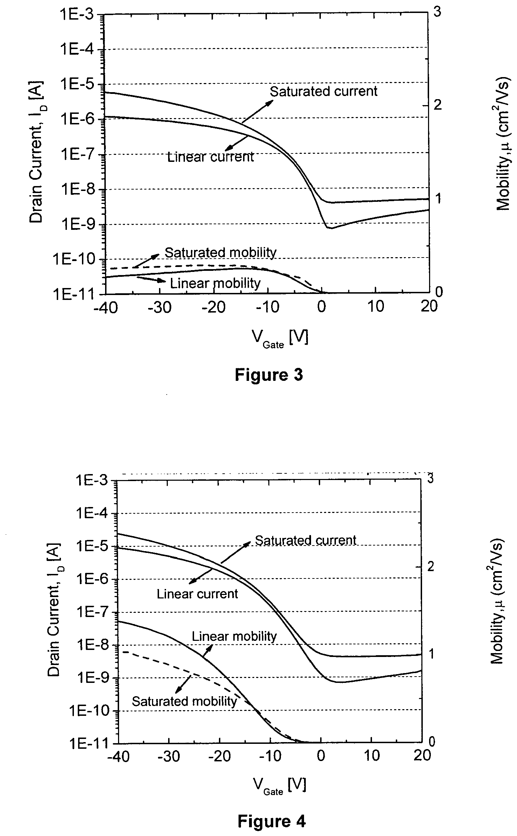

The transfer characteristics was recorded using a transfer measurement system at a bias voltage of -5 V (linear region) and -60V (saturation region). The transfer characteristics are shown in **Figure 3****.**

The characteristics indicate a good transistor performance with hole mobility between 0.3 cm²/Vs (saturated mobility) and 0.25 cm²/Vs (linear mobility).

### Example 3

An OSC formulation is prepared as described in Example 2, except that the ratio binder:OSC:solvent is 1.1:0.9:98, so that the ratio binder:OSC is reduced to 1.1:0.9 (or approx. 6:5), compared to Example 2.

The adhesion of the formulation to Parylene C is 1N, measured by a 90° peel test.

Compared to Example 2, the adhesion of the OSC formulation of Example 3 to Parylene is lower. This can be explained by the reduction of the amount of organic binder.

A top gate OFET device is prepared from this OSC formulation in analogy to Example 2. The transfer characteristics was recorded using a transfer measurement system at a bias voltage of -5 V (linear region) and -60V (saturation region). The transfer characteristics are shown in **Figure 4****.**

Compared to Example 2, the transfer characteristic is improved and the mobility is increased to values between 1.3 cm²/Vs (linear mobility) and 1.1 cm²/Vs (saturated mobility).

These results confirm that the organic binder acts as adhesion promoter, and that, by adjusting the proportion of organic binder towards active OSC, the adhesion of the OSC layer to the Parylene gate dielectric and the OFET device performance can be optimised depending on the specific requirements.

### Example 4

An OSC formulation is prepared using triphenyldiamine (TPD) as organic binder mixed with 2,8-Difluoro-5,11-bis(triethylsilylethynyl) anthradithiophene as OSC and dissolved in cyclohexylbenzene: mesitylene(80:20) at a ratio of binder:OSC:solvent of 1.33:0.66:98.01 so that the ratio binder:OSC is 2:1.

The adhesion of the formulation to Parylene C is above 8N/50mm, measured by a 90° peel test.

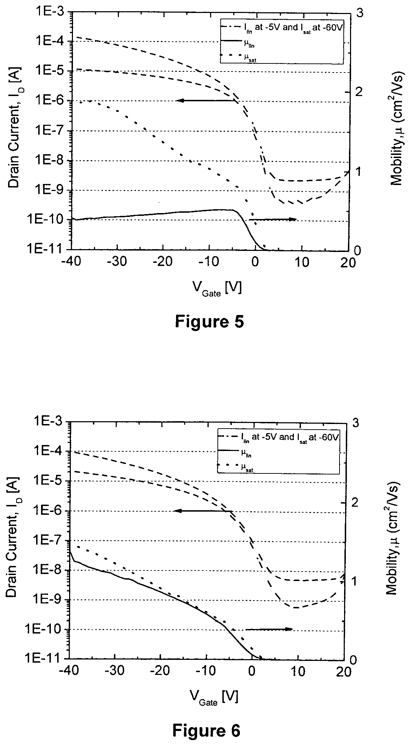

A top gate OFET device is prepared from this OSC formulation in analogy to Example 2. The transfer characteristics was recorded using a transfer measurement system at a bias voltage of -5 V (linear region) and -60V (saturation region). The transfer characteristics are shown in **Figure 5****.**

The transfer characteristic of device in Example 4 showed that the linear mobility (0.5 cm²/Vs) is lower compare to saturated mobility (∼2 cm²/Vs).

### Example 5

An OSC formulation is prepared as described in Example 4 except that the ratio binder:OSC:solvent is 0.66:1.33:98.01, so that the ratio binder:OSC is reduced to 1:2.

The transfer characteristic of example 5 shown in **Figure 6** have similar mobilities in linear and saturated regimes, which are around 1.4 cm²/Vs (linear mobility) and 1.3 cm²/Vs (saturated mobility).

The adhesion of the formulation in Example 5 to Parylene C is 0.5N, measured by a 90° peel test.

Compared to Example 4, the adhesion of the OSC formulation in Example 5 to Parylene is lower, which can be explained by the reduction of the amount of organic binder. However the device performance in terms of Iₒₙ is similar for the devices of Example 4 and 5, as can be seen in **Figure 5** and **6****.**

Examples 4 and 5 show that by changing the ration of binder versus OSC, the adhesion between OSC and parylene dielectric can be improved without compromising the device performance significantly.

## Claims

1. An organic electronic device comprising
- an organic semiconducting (OSC) layer comprising an organic semiconductor and an organic binder,
- an electrode and
- a dielectric layer located between said OSC layer and said electrode, **characterized in that**
- the dielectric layer comprises polymerized p-xylylene that is optionally substituted, and
- the organic binder comprises a compound comprising one or more divalent units selected from formula 1, 2 and 3 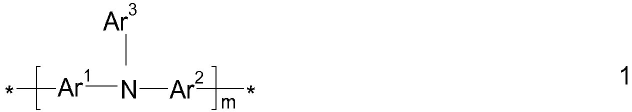 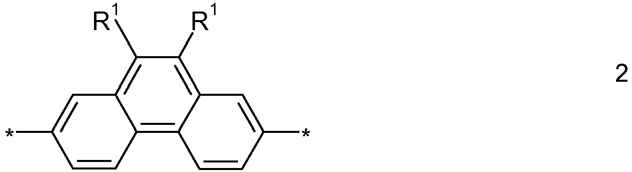 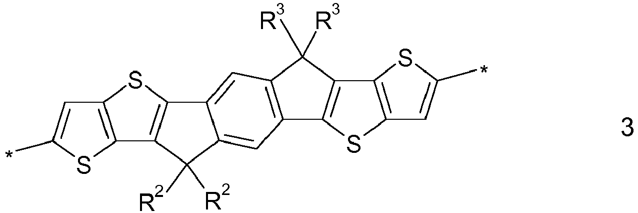 wherein
Ar¹, Ar² and Ar³ denote, independently of each other and on each occurrence identically or differently, an optionally substituted mononuclear or polynuclear aryl or heteroaryl group, Ar¹ may also denote a single bond, and Ar³ may also have one of the meanings of R¹,
m is 1, 2 or 3,
R¹, R², R³ independently of each other, and on each occurrence identically or differently, denote H, F, Cl, Br, CN, straight-chain, branched or cyclic alkyl, with 1 to 30 C atoms, in which one or more non-adjacent C atoms are optionally replaced by -O-, -S-, -C(O)-, -C(O)-O-, -O-C(O)-, -O-C(O)-O-, -C(S)-, -C(S)-O-, -O-C(S)-, -O-C(S)-O-, -C(O)-S-, -S-C(O)-, -O-C(O)-S-, -S-C(O)-O-, -S-C(O)-S-, -S-C(S)-S-, -O-C(S)-S-, -S-C(S)-O-,-C(S)-S-, -S-C(S)-, -NR⁰-, -SiR⁰R⁰⁰-, -CY¹=CY²- or-C≡C- in such a manner that O and/or S atoms are not linked directly to one another, and in which one or more H atoms are optionally replaced by F, Cl, Br, I or CN, or R¹ and R², independently of each other, and on each occurrence identically or differently, denote aryl, heteroaryl, aryloxy or heteroaryloxy with 4 to 20 ring atoms which is optionally substituted, or R¹ and R² together form an alicyclic group with 1 to 20 C atoms, which is optionally fluorinated or alkylated,
Y¹ and Y² are independently of each other H, F, Cl or CN,
R⁰ and R⁰⁰ are independently of each other H or optionally substituted C₁₋₄₀ carbyl or hydrocarbyl, and preferably denote H or alkyl with 1 to 12 C-atoms.

2. The organic electronic device according to claim 1, wherein the organic binder is selected from small molecules of formula M1 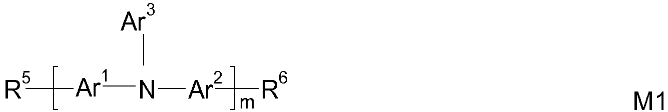 wherein Ar¹⁻³ and m are as defined in claim 1, and R⁵ and R⁶, which may be the same or different, are selected from H, halogen, silyl, substituted or unsubstituted aryl or heteroaryl having from 3 to 20 C atoms, alkyl, alkoxy, alkylthio, alkylcarbonyl, alkoxycarbonyl, alkylcarbonyloxy, each having from 1 to 20 C atoms, or cycloalkyl, arylalkyl, aryloxy or arylthio, each having from 3 to 20 C atoms.

3. The organic electronic device according to claim 1 or 2, wherein the organic binder is selected from polymers comprising a unit selected from the following subformulae: 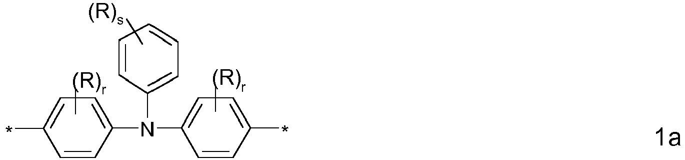 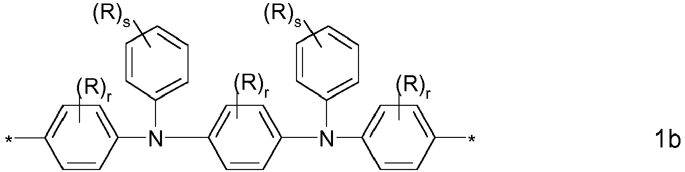 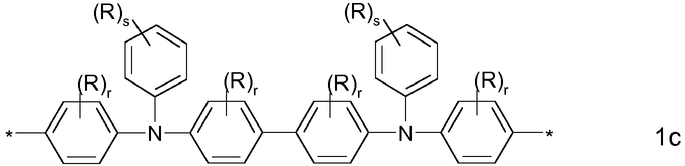 wherein R has one of the meanings of R¹ as given in claim 1, r is 0, 1, 2, 3 or 4, and s is 0, 1, 2, 3, 4 or 5.

4. The organic electronic device according to claim 3, wherein the organic binder is selected from polymers of the following formulae: 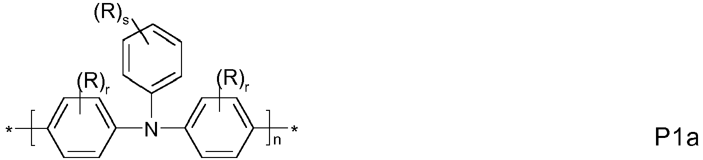 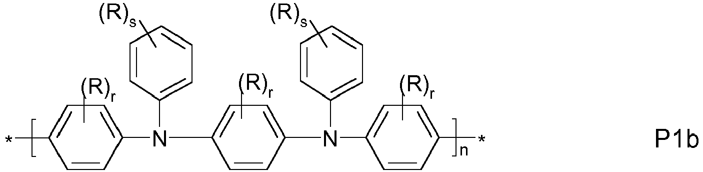 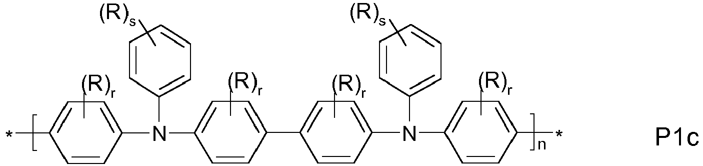 wherein R, r and s are as defined in claim 3 and n is an integer >1.

5. The organic electronic device according to claim 1 or 3, wherein the organic binder is selected from co-polymers comprising one or more units of formula 1 or its subformulae 1a-c, and further comprising one or more additional units selected from arylene and heteroarylene units that are optionally substituted.

6. The organic electronic device according to claim 5, wherein the organic binder is selected from co-polymers of the following formulae: 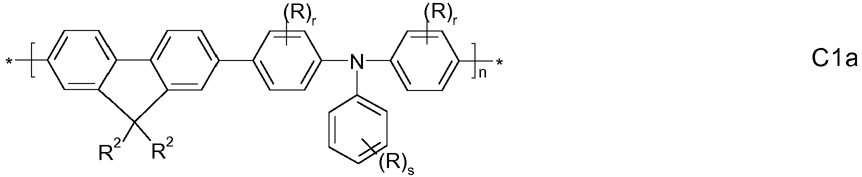 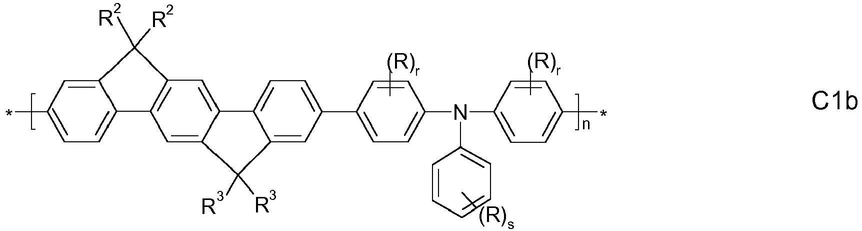 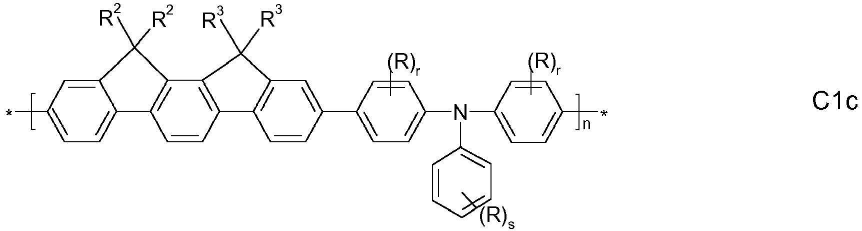 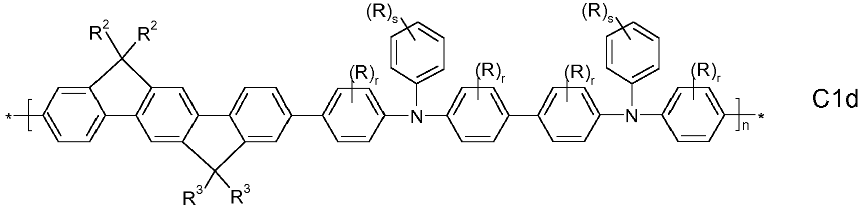 wherein R² and R³ are as defined in claim 1, and R, r, s and n are as defined in claim 4.

7. The organic electronic device according to claim 1, wherein the organic binder is selected from co-polymers comprising one or more units of formula 2 and one or more co-units selected from arylene and heteroarylene units that are optionally substituted.

8. The organic electronic device according to claim 1, wherein the organic binder is selected from polymers comprising one or more units of formula 3 and optionally comprising one or more co-units selected from arylene and heteroarylene units that are optionally substituted.

9. The organic electronic device according to claim 8, wherein the organic binder is selected from polymers of the following formulae: 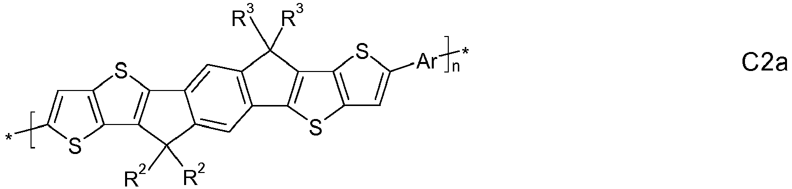 wherein R² and R³ are as defined in claim 1, and R, r, s and n are as defined in claim 4 and Ar has one of the meanings of Ar¹ in claim 1.

10. The organic electronic device according to claim 9, wherein the organic binder is selected from polymers of the following formulae: 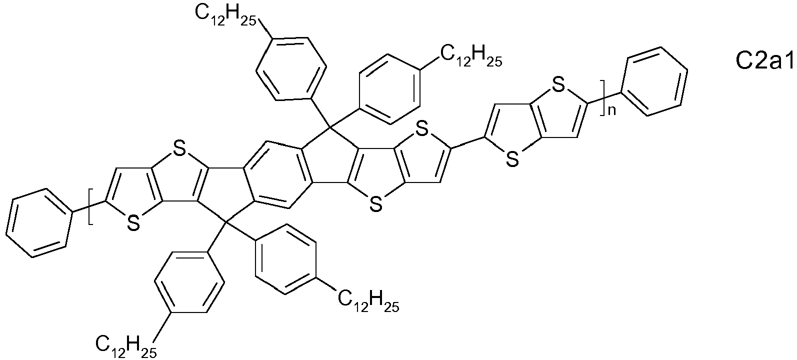 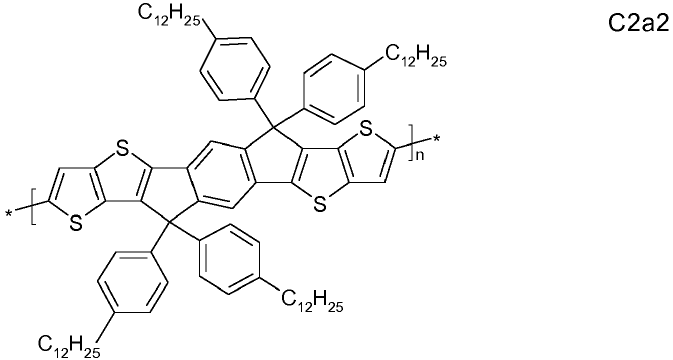 wherein n is an integer >1.

11. The organic electronic device according to claim 1, wherein the organic binder is selected from co-polymers comprising one or more repeating units selected from one of formulae 1, 2 and 3, and one or more repeating units selected from another one of formulae 1, 2 and 3.

12. The organic electronic device according to claim 11, wherein the organic binder is selected from co-polymers of the following formulae: 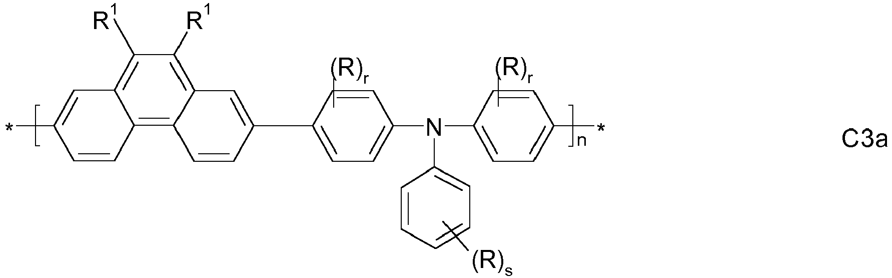 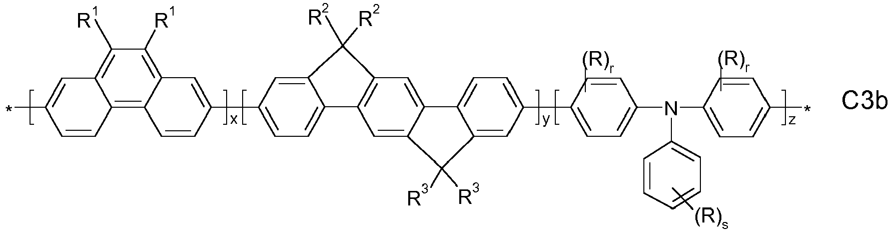 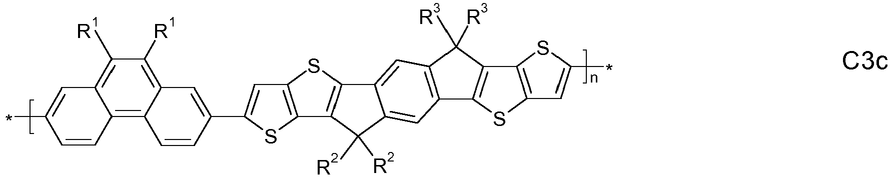 wherein R¹, R² and R³ are as defined in claim 1, R, r, s and n are as defined in claim 4, and x, y and z denote the mole fraction of the respective unit in the co-polymer, and x, y and z are each >0 and <1.

13. The organic electronic device according to one or more of claims 1 to 12, wherein R is alkyl with 1 to 5 C atoms, and R² and R³ denote, independently of each other, straight-chain or branched alkyl with 1 to 20 C atoms, or aryl with 5 to 12 C atoms that is optionally substituted with C1-12 alkyl or C1-12 alkoxy.

14. The organic electronic device according to one or more of claims 1 to 13, wherein the organic semiconductor comprises a small molecule.

15. The organic electronic device according to claim 14, wherein the organic semiconductor comprises an oligoacene or a substituted oligoacene.

16. The organic electronic device according to claim 15, wherein the oligoacene is an anthracene, a tetracene, a pentacene or an anthradithiophene, all of which are optionally substituted with two or more trialkylsilylethynyl groups and/or fluorinated.

17. The organic electronic device according to one or more of claims 1 to 16, which is an Organic Field Effect Transistor (OFET), Organic Thin Film Transistor (OTFT), Organic Light Emitting Diode (OLED) or Organic Photovoltaic (OPV) device.

18. The organic electronic device according to claim 17, which is a top gate OFET or bottom gate OFET.

19. A product or assembly comprising an organic electronic device according to one or more of claims 1 to 18, which is an Integrated Circuit (IC), a Radio Frequency Identification (RFID) tag, a security marking or security device containing an RFID tag, a Flat Panel Display (FPD), a backplane of an FPD, a backlight of an FPD, an electrophotographic device, an electrophotographic recording device, an organic memory device, a pressure sensor, an optical sensor, a chemical sensor, a biosensor or a biochip.

## Patentansprüche

1. Organische elektronische Vorrichtung enthaltend
- eine organische Halbleiterschicht (OSC (organic semiconducting)-Schicht) enthaltend einen organischen Halbleiter und ein organisches Bindemittel,
- eine Elektrode und
- eine zwischen der OSC-Schicht und der Elektrode angeordnete dielektrische Schicht, **dadurch gekennzeichnet, dass**
- die dielektrische Schicht polymerisiertes p-Xylylen enthält, das gegebenenfalls substituiert ist, und
- das organische Bindemittel eine Verbindung enthält, die eine oder mehrere zweiwertige Einheiten ausgewählt aus der Formel 1, 2 und 3 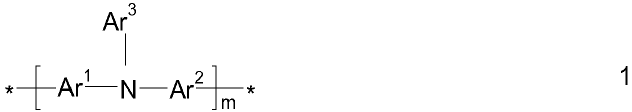 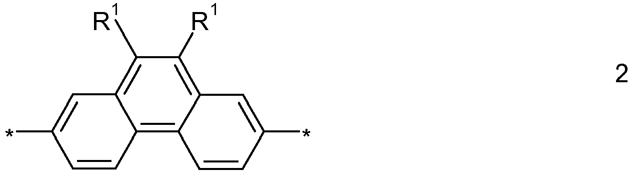 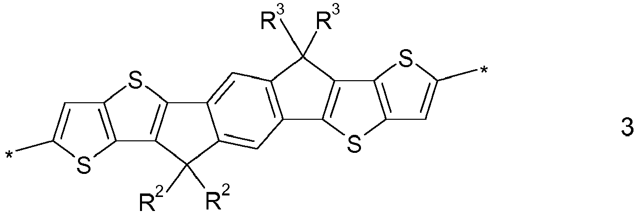 enthält, bei denen
Ar¹, Ar² und Ar³ unabhängig voneinander und bei jedem Auftreten gleich oder verschieden eine gegebenenfalls substituierte einkernige oder mehrkernige Aryl- oder Heteroarylgruppe bedeuten, Ar¹ auch eine Einfachbindung bedeuten kann und Ar³ auch eine der Bedeutungen von R¹ besitzen kann,
m 1, 2 oder 3 ist,
R¹, R², R³ unabhängig voneinander und bei jedem Auftreten gleich oder verschieden H, F, Cl, Br, CN, geradkettiges, verzweigtes oder cyclisches Alkyl, mit 1 bis 30 C-Atomen bedeuten, worin gegebenenfalls ein oder mehrere nicht benachbarte C-Atome so durch -O-, -S-, -C(O)-, -C(O)-O-, -O-C(O)-, -O-C(O)-O-, -C(S)-, -C(S)-O-, -O-C(S)-, -O-C(S)-O-, -C(O)-S-, -S-C(O)-, -O-C(O)-S-, -S-C(O)-O-, -S-C(O)-S-, -S-C(S)-S-, -O-C(S)-S-, -S-C(S)-O-, -C(S)-S-, -S-C(S)-, -NR⁰-, -SiR⁰R⁰⁰-, -CY¹=CY²- oder -C≡C- ersetzt sind, dass O- und/oder S-Atome nicht direkt miteinander verknüpft sind, und worin gegebenenfalls ein oder mehrere H-Atome durch F, Cl, Br, I oder CN ersetzt sind, oder R¹ und R² bedeuten unabhängig voneinander und bei jedem Auftreten gleich oder verschieden Aryl, Heteroaryl, Aryloxy oder Heteroaryloxy mit 4 bis 20 Ringatomen, das gegebenenfalls substituiert ist, oder R¹ und R² bilden zusammen eine alicyclische Gruppe mit 1 bis 20 C-Atomen, die gegebenenfalls fluoriert oder alkyliert ist,
Y¹ und Y² unabhängig voneinander H, F, Cl oder CN sind,
R⁰ und R⁰⁰ unabhängig voneinander H oder gegebenenfalls substituiertes C₁₋₄₀-Carbyl oder -Hydrocarbyl sind und vorzugsweise H oder Alkyl mit 1 bis 12 C-Atomen bedeuten.

2. Organische elektronische Vorrichtung nach Anspruch 1, bei der das organische Bindemittel aus kleinen Molekülen der Formel M1 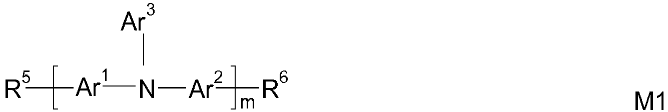 ausgewählt ist, bei der Ar¹⁻³ und m wie in Anspruch 1 definiert sind und R⁵ und R⁶, die gleich oder verschieden sein können, aus H, Halogen, Silyl, substituiertem oder unsubstituiertem Aryl oder Heteroaryl mit 3 bis 20 C-Atomen, Alkyl, Alkoxy, Alkylthio, Alkylcarbonyl, Alkoxycarbonyl, Alkylcarbonyloxy, jeweils mit 1 bis 20 C-Atomen, oder Cycloalkyl, Arylalkyl, Aryloxy oder Arylthio, jeweils mit 3 bis 20 C-Atomen, ausgewählt sind.

3. Organische elektronische Vorrichtung nach Anspruch 1 oder 2, bei der das organische Bindemittel aus Polymeren ausgewählt ist, die eine Einheit enthalten, die aus den folgenden Unterformeln ausgewählt ist: 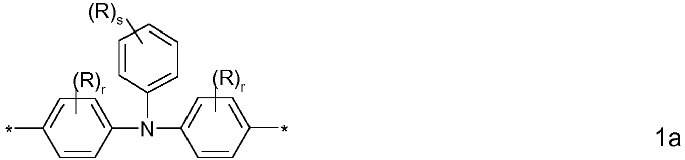 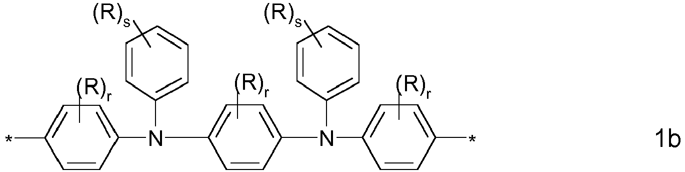 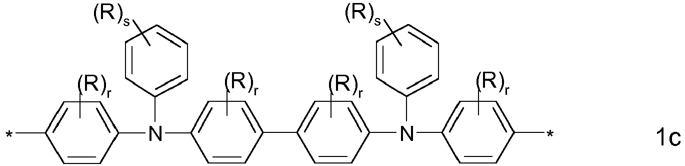 bei denen R eine der Bedeutungen von R¹ wie in Anspruch 1 gegeben besitzt, r 0, 1, 2, 3 oder 4 ist und s 0, 1, 2, 3, 4 oder 5 ist.

4. Organische elektronische Vorrichtung nach Anspruch 3, bei der das organische Bindemittel aus Polymeren der folgenden Formeln ausgewählt ist: 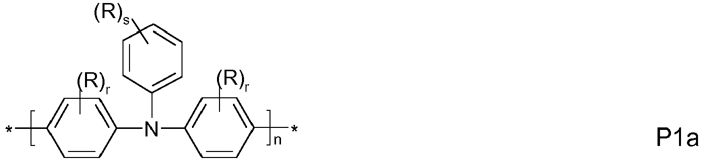 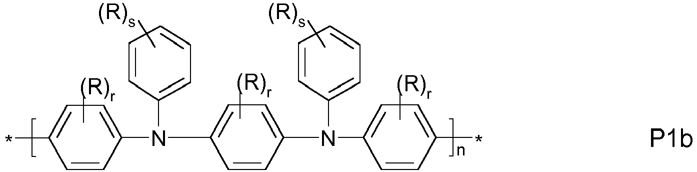 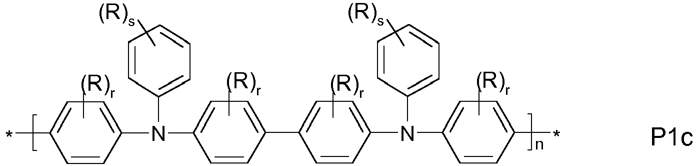 bei denen R, r und s wie in Anspruch 3 definiert sind und n eine ganze Zahl >1 ist.

5. Organische elektronische Vorrichtung nach Anspruch 1 oder 3, bei der das organische Bindemittel aus Copolymeren enthaltend eine oder mehrere Einheiten der Formel 1 oder ihrer Unterformeln 1a-c ausgewählt ist, und weiterhin enthaltend eine oder mehrere zusätzliche Einheiten, die aus gegebenenfalls substituierten Arylen- und Heteroaryleneinheiten ausgewählt sind.

6. Organische elektronische Vorrichtung nach Anspruch 5, bei der das organische Bindemittel aus Copolymeren der folgenden Formeln ausgewählt ist: 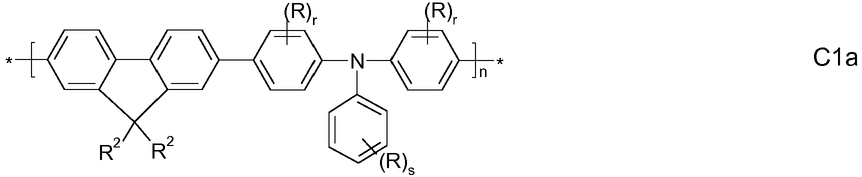 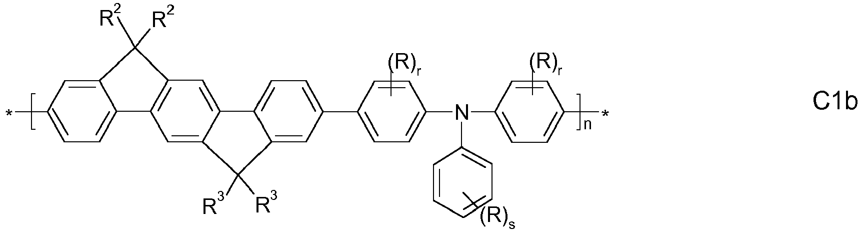 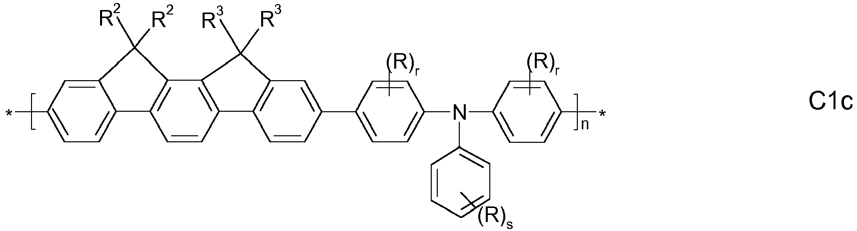 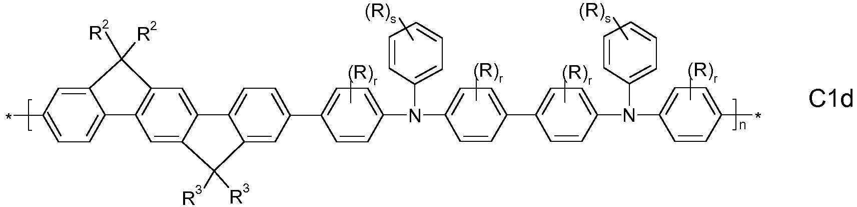 bei denen R² und R³ wie in Anspruch 1 definiert sind und R, r, s und n wie in Anspruch 4 definiert sind.

7. Organische elektronische Vorrichtung nach Anspruch 1, bei der das organische Bindemittel aus Copolymeren ausgewählt ist, die eine oder mehrere Einheiten der Formel 2 und eine oder mehrere Co-Einheiten, die aus gegebenenfalls substituierten Arylen- und Heteroaryleneinheiten ausgewählt sind, enthalten.

8. Organische elektronische Vorrichtung nach Anspruch 1, bei der das organische Bindemittel aus Polymeren ausgewählt ist, die eine oder mehrere Einheiten der Formel 3 enthalten und gegebenenfalls eine oder mehrere Co-Einheiten, die aus gegebenenfalls substituierten Arylen- und Heteroaryleneinheiten ausgewählt sind, enthalten.

9. Organische elektronische Vorrichtung nach Anspruch 8, bei der das organische Bindemittel aus Polymeren der folgenden Formel ausgewählt ist: 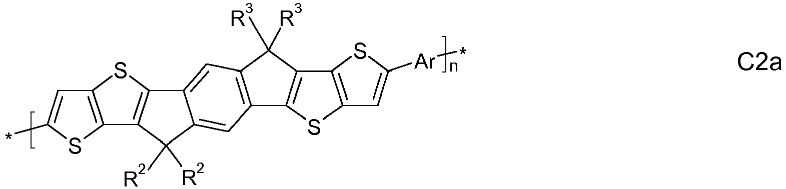 bei der R² und R³ wie in Anspruch 1 definiert sind und R, r, s und n wie in Anspruch 4 definiert sind und Ar eine der Bedeutungen von Ar¹ in Anspruch 1 besitzt.

10. Organische elektronische Vorrichtung nach Anspruch 9, bei der das organische Bindemittel aus Polymeren der folgenden Formeln ausgewählt ist: 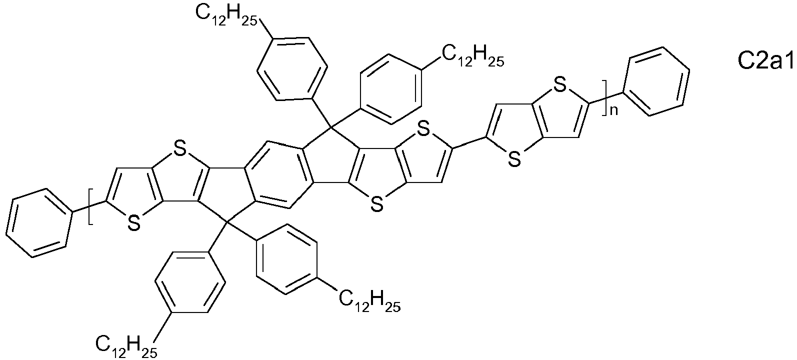 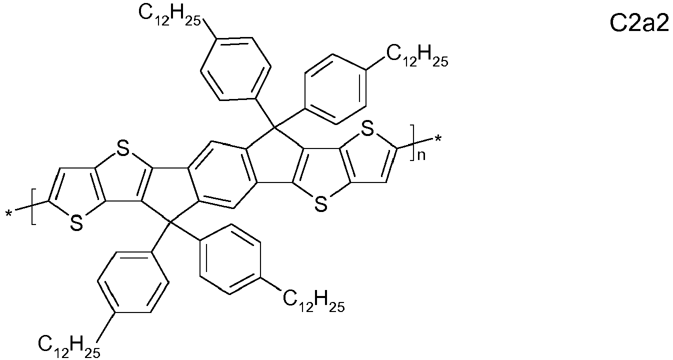 bei denen n eine ganze Zahl >1 ist.

11. Organische elektronische Vorrichtung nach Anspruch 1, bei der das organische Bindemittel aus Copolymeren ausgewählt ist, die eine oder mehrere aus einer der Formeln 1, 2 und 3 ausgewählte Wiederholungseinheiten und eine oder mehrere aus einer anderen der Formeln 1, 2 und 3 ausgewählte Wiederholungseinheiten enthalten.

12. Organische elektronische Vorrichtung nach Anspruch 11, bei der das organische Bindemittel aus Copolymeren der folgenden Formeln ausgewählt ist: 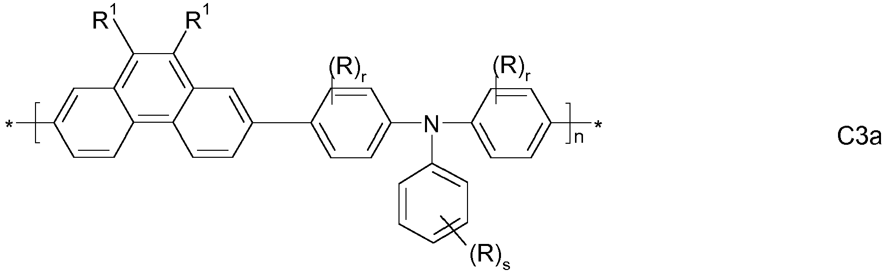 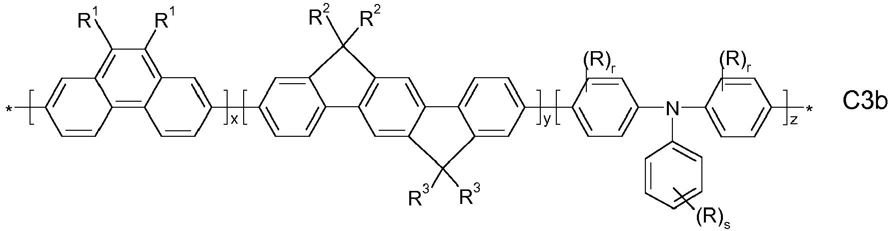 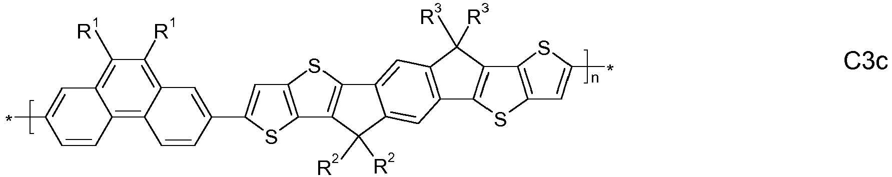 bei denen R¹, R² und R³ wie in Anspruch 1 definiert sind, R, r, s und n wie in Anspruch 4 definiert sind und x, y und z den Molenbruch der jeweiligen Einheit in dem Copolymer bedeuten und x, y und z jeweils >0 und <1 sind.

13. Organische elektronische Vorrichtung nach einem oder mehreren der Ansprüche 1 bis 12, bei der R Alkyl mit 1 bis 5 C-Atomen ist und R² und R³ unabhängig voneinander geradkettiges oder verzweigtes Alkyl mit 1 bis 20 C-Atomen oder Aryl mit 5 bis 12 C-Atomen, das gegebenenfalls mit C₁₋₁₂-Alkyl oder C₁₋₁₂-Alkoxy substituiert ist, bedeuten.

14. Organische elektronische Vorrichtung nach einem oder mehreren der Ansprüche 1 bis 13, bei der der organische Halbleiter ein kleines Molekül enthält.

15. Organische elektronische Vorrichtung nach Anspruch 14, bei der der organische Halbleiter ein Oligoacen oder ein substituiertes Oligoacen enthält.

16. Organische elektronische Vorrichtung nach Anspruch 15, bei der es sich bei dem Oligoacen um ein Anthracen, ein Tetracen, ein Pentacen oder ein Anthradithiophen handelt, die alle gegebenenfalls mit zwei oder mehr Trialkylsilylethinylgruppen substituiert und/oder fluoriert sind.

17. Organische elektronische Vorrichtung nach einem oder mehreren der Ansprüche 1 bis 16, bei der es sich um einen organischen Feldeffekttransistor (OFET), organischen Dünnschichttransistor (Organic Thin Film Transistor - OTFT), eine organische Leuchtdiode (Organic Light Emitting Diode - OLED) oder organische photovoltaische (OPV) Vorrichtung handelt.

18. Organische elektronische Vorrichtung nach Anspruch 17, bei der es sich um einen Top-Gate-OFET oder Bottom-Gate-OFET handelt.

19. Produkt oder Baugruppe enthaltend eine organische elektronische Vorrichtung nach einem oder mehreren der Ansprüche 1 bis 18, bei dem/der es sich um eine integrierte Schaltung (Integrated Circuit - IC), ein RFID-Tag (RFID - Radio Frequency Identification), eine Sicherheitsmarkierung oder Sicherheitsvorrichtung enthaltend ein RFID-Tag, einen Flachbildschirm (Flat Panel Display - FPD), eine Rückplatte eines FPD, eine Hintergrundbeleuchtung eines FPD, eine elektrophotographische Vorrichtung, eine elektrophotographische Aufzeichnungsvorrichtung, eine organische Speichervorrichtung, einen Drucksensor, einen optischen Sensor, einen chemischen Sensor, einen Biosensor oder einen Biochip handelt.

## Revendications

1. Dispositif électronique organique comprenant :
- une couche de semiconduction organique (OSC) qui comprend un semiconducteur organique et un agent de liaison organique ;
- une électrode ; et
- une couche diélectrique qui est localisée entre ladite couche OSC et ladite électrode ;
**caractérisé en ce que** :
- la couche diélectrique comprend du p-xylylène polymérisé qui est en option substitué ;
- l'agent de liaison organique comprend un composé qui comprend une ou plusieurs unité(s) divalente(s) qui est/sont sélectionnée(s) parmi les formules 1, 2 et 3 : 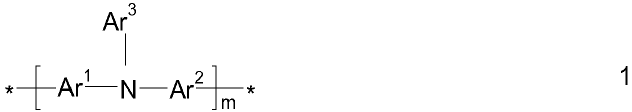 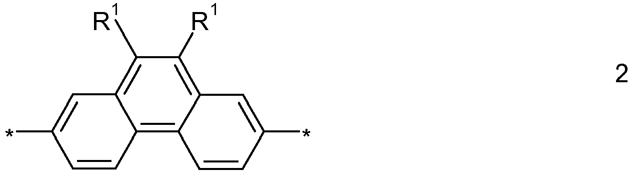 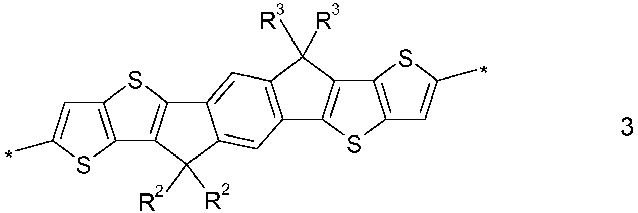 dans lesquelles :
Ar¹, Ar² et Ar³ représentent, de manière indépendante les uns des autres, et pour chaque occurrence, de manière identique ou différente, un groupe aryle ou hétéroaryle mononucléaire ou polynucléaire en option substitué, Ar¹ peut également représenter une liaison simple, et Ar³ peut également présenter l'une des significations de R¹ ;
m est 1, 2 ou 3 ;
R¹, R², R³ représentent, de manière indépendante les uns des autres, et pour chaque occurrence, de manière identique ou différente, H, F, Cl, Br, CN, alkyle en chaîne droite, ramifié ou cyclique qui comporte de 1 à 30 atome(s) de C, où un ou plusieurs atome(s) de C non adjacents est/sont en option remplacé(s) par -O-, -S-, -C(O)-, -C(O)-O-, -O-C(O)-, -O-C(O)-O-, -C(S)-, -C(S)-O-, -O-C(S)-, -O-C(S)-O-, -C(O)-S-, -S-C(O)-, -O-C(O)-S-, -S-C(O)-O-, -S-C(O)-S-, -S-C(S)-S-, -O-C(S)-S-, -S-C(S)-O-, -C(S)-S-, -S-C(S)-, -NR⁰-, -SiR⁰R⁰⁰-, -CY¹=CY²- ou -C≡C- de telle sorte que des atomes de O et/ou des atomes de S ne soient pas liés directement les uns aux autres, et où un ou plusieurs atome(s) de H est/sont en option remplacé(s) par F, Cl, Br, I ou CN, ou R¹ et R² représentent, de manière indépendante l'un de l'autre, et pour chaque occurrence, de manière identique ou différente, aryle, hétéroaryle, aryloxy ou hétéroaryloxy qui comporte de 4 à 20 atomes de cycle, lequel est en option substitué, ou R¹ et R² forment ensemble un groupe alicyclique qui comporte de 1 à 20 atome(s) de C, lequel est en option fluoré ou alkylaté ;
Y¹ et Y² sont, de manière indépendante l'un de l'autre, H, F, Cl ou CN ;
R⁰ et R⁰⁰ sont, de manière indépendante l'un de l'autre, H ou C₁₋₄₀ carbyle ou hydrocarbyle en option substitué, et ils représentent de préférence H ou alkyle qui comporte de 1 à 12 atome(s) de C.

2. Dispositif électronique organique selon la revendication 1, dans lequel l'agent de liaison organique est sélectionné parmi les petites molécules de la formule M1 : 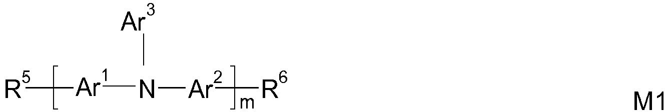 dans laquelle Ar¹⁻³ et m sont comme il a été défini selon la revendication 1, et R⁵ et R⁶, qui peuvent être les mêmes ou qui peuvent être différents, sont sélectionnés parmi H, halogène, silyle, aryle ou hétéroaryle substitué ou non substitué qui comporte de 3 à 20 atomes de C, alkyle, alcoxy, alkylthio, alkylcarbonyle, alcoxycarbonyle, alkylcarbonyloxy, dont chacun comporte de 1 à 20 atome(s) de C, ou cycloalkyle, arylalkyle, aryloxy ou arylthio, dont chacun comporte de 3 à 20 atomes de C.

3. Dispositif électronique organique selon la revendication 1 ou 2, dans lequel l'agent de liaison organique est sélectionné parmi les polymères qui comprennent une unité qui est sélectionnée parmi les sous-formules qui suivent : 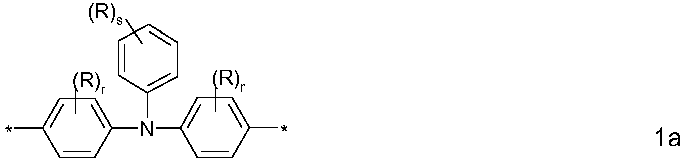 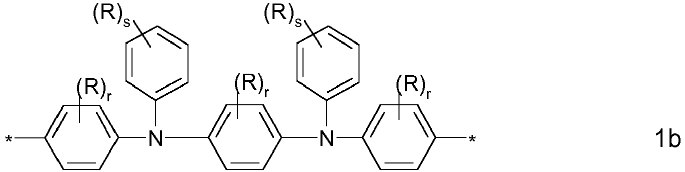 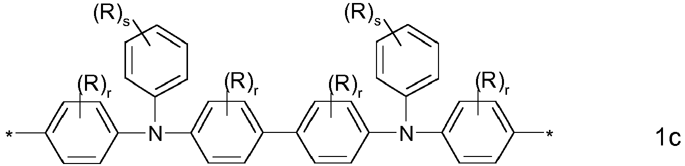 dans lesquelles R présente l'une des significations de R¹ comme il a été mentionné selon la revendication 1, r est 0, 1, 2, 3 ou 4, et s est 0, 1, 2, 3, 4 ou 5.

4. Dispositif électronique organique selon la revendication 3, dans lequel l'agent de liaison organique est sélectionné parmi les polymères des formules qui suivent : 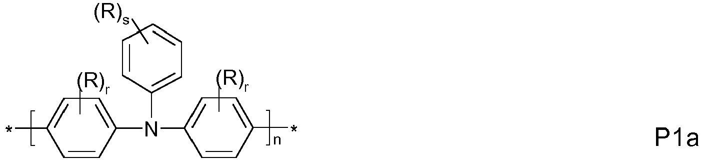 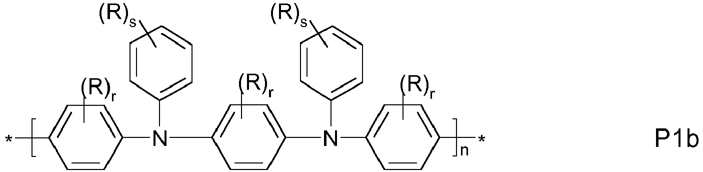 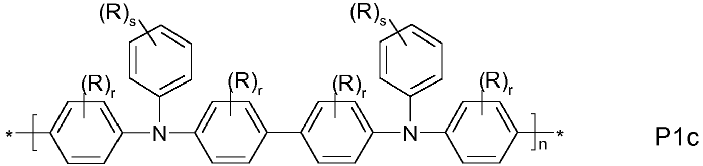 dans lesquelles R, r et s sont comme il a été défini selon la revendication 3 et n est un entier > 1.

5. Dispositif électronique organique selon la revendication 1 ou 3, dans lequel l'agent de liaison organique est sélectionné parmi les copolymères qui comprennent une ou plusieurs unité(s) de la formule 1 ou de sa sous-formule 1a-c, et comprenant en outre une ou plusieurs unité(s) additionnelle(s) qui est/sont sélectionnée(s) parmi les unités arylène et hétéroarylène et qui est/sont en option substituée(s).

6. Dispositif électronique organique selon la revendication 5, dans lequel l'agent de liaison organique est sélectionné parmi les copolymères des formules qui suivent : 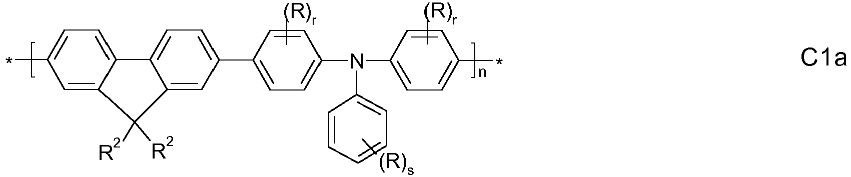 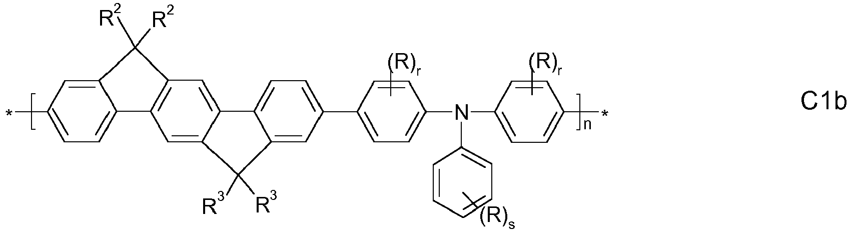 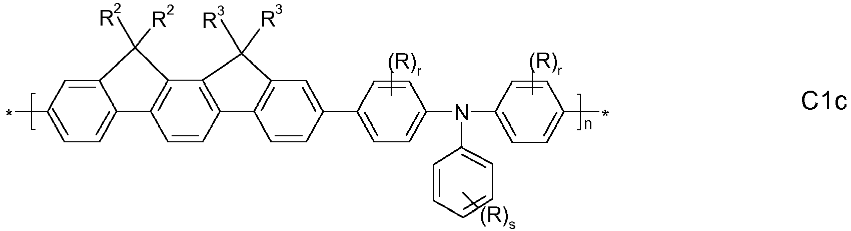 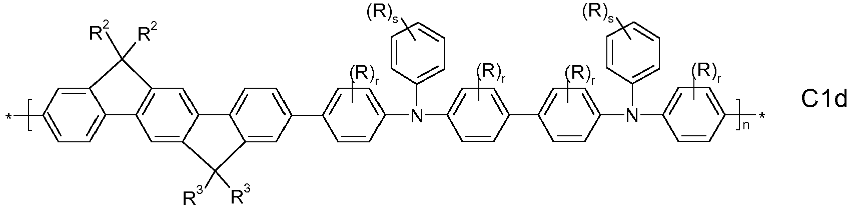 dans lesquelles R² et R³ sont comme il a été défini selon la revendication 1, et R, r, s et n sont comme il a été défini selon la revendication 4.

7. Dispositif électronique organique selon la revendication 1, dans lequel l'agent de liaison organique est sélectionné parmi les copolymères qui comprennent une ou plusieurs unité(s) de la formule 2 et une ou plusieurs co-unité(s) qui est/sont sélectionnée(s) parmi les unités arylène et hétéroarylène et qui est/sont en option substituée(s).

8. Dispositif électronique organique selon la revendication 1, dans lequel l'agent de liaison organique est sélectionné parmi les polymères qui comprennent une ou plusieurs unité(s) de la formule 3 et en option, comprenant une ou plusieurs co-unité(s) qui est/sont sélectionnée(s) parmi les unités arylène et hétéroarylène et qui est/sont en option substituée(s).

9. Dispositif électronique organique selon la revendication 8, dans lequel l'agent de liaison organique est sélectionné parmi les polymères de la formule qui suit : 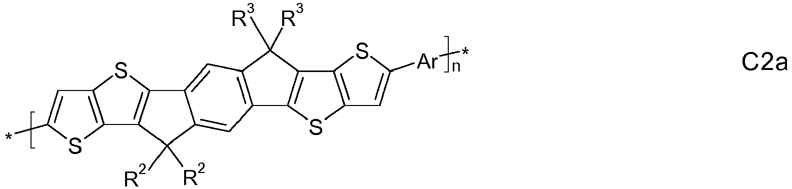 dans laquelle R² et R³ sont comme il a été défini selon la revendication 1, et R, r, s et n sont comme il a été défini selon la revendication 4 et Ar présente l'une des significations de Ar¹ selon la revendication 1.

10. Dispositif électronique organique selon la revendication 9, dans lequel l'agent de liaison organique est sélectionné parmi les polymères des formules qui suivent : 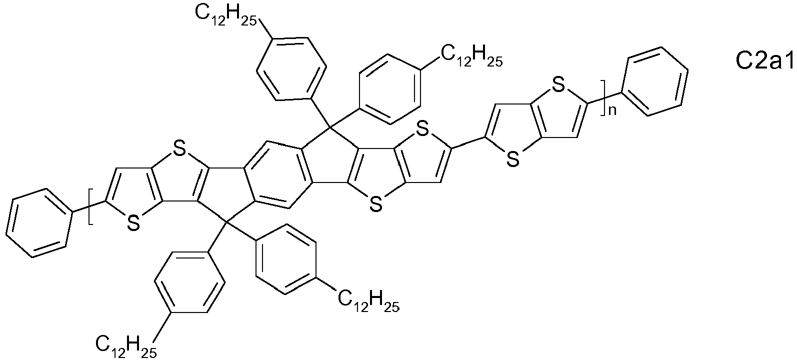 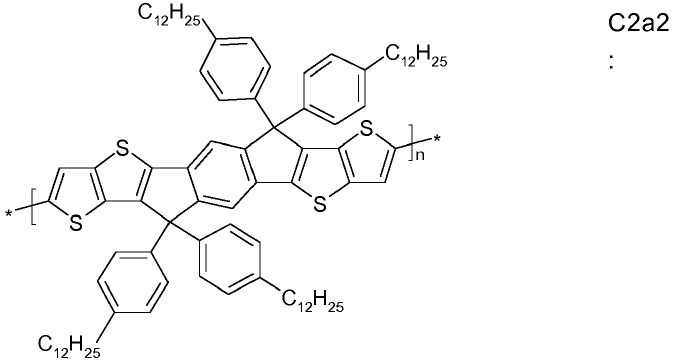 dans lesquelles n est un entier > 1.

11. Dispositif électronique organique selon la revendication 1, dans lequel l'agent de liaison organique est sélectionné parmi les copolymères qui comprennent une ou plusieurs unité(s) de répétition qui est/sont sélectionnée(s) parmi l'une des formules 1, 2 et 3, et une ou plusieurs unité(s) de répétition qui est/sont sélectionnée(s) parmi une autre des formules 1, 2 et 3.

12. Dispositif électronique organique selon la revendication 11, dans lequel l'agent de liaison organique est sélectionné parmi les copolymères des formules qui suivent : 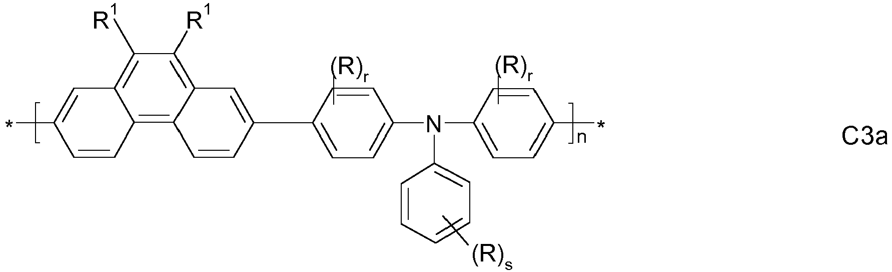 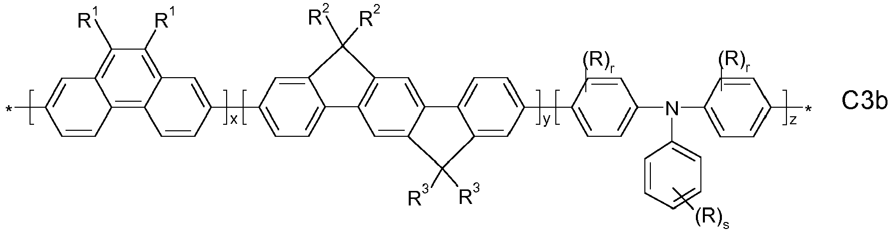 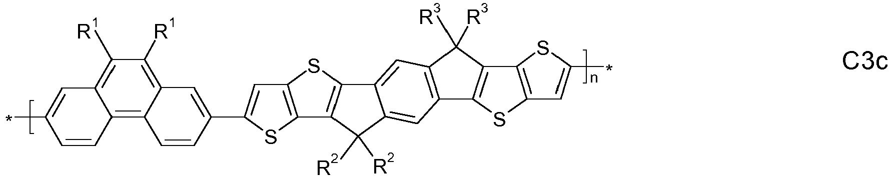 dans lesquelles R¹, R² et R³ sont comme il a été défini selon la revendication 1, R, r, s et n sont comme il a été défini selon la revendication 4, et x, y et z représentent la fraction molaire de l'unité respective dans le copolymère, et x, y et z sont chacun > 0 et < 1.

13. Dispositif électronique organique selon une ou plusieurs des revendications 1 à 12, dans lequel R est alkyle qui comporte de 1 à 5 atome(s) de C, et R² et R³ représentent, de manière indépendante l'un de l'autre, alkyle en chaîne droite ou ramifié qui comporte de 1 à 20 atome(s) de C, ou aryle qui comporte de 5 à 12 atomes de C et qui est en option substitué par C₁₋₁₂ alkyle ou par C1-12 alcoxy.

14. Dispositif électronique organique selon une ou plusieurs des revendications 1 à 13, dans lequel le semiconducteur organique comprend une petite molécule.

15. Dispositif électronique organique selon la revendication 14, dans lequel le semiconducteur organique comprend un oligoacène ou un oligoacène substitué.

16. Dispositif électronique organique selon la revendication 15, dans lequel l'oligoacène est un anthracène, un tétracène, un pentacène ou un anthradithiophène, dont tous sont en option substitués par deux groupes trialkylsilyléthynyle ou plus et/ou sont fluorés.

17. Dispositif électronique organique selon une ou plusieurs des revendications 1 à 16, lequel est un transistor à effet de champ organique (OFET), un transistor à film mince organique (OTFT), une diode électroluminescente organique (OLED) ou un dispositif photovoltaïque organique (OPV).

18. Dispositif électronique organique selon la revendication 17, lequel est un OFET à grille en sommet ou un OFET à grille en fond.

19. Produit ou assemblage comprenant un dispositif électronique organique selon une ou plusieurs des revendications 1 à 18, lequel est un circuit intégré (IC), une étiquette d'identification radiofréquence (RFID), un marquage de sécurité ou un dispositif de sécurité qui contient une étiquette RFID, un affichage à écran plat (FPD), un plan arrière d'un FPD, un éclairage arrière d'un FPD, un dispositif électrophotographique, un dispositif d'enregistrement électrophotographique, un dispositif de mémoire organique, un capteur de pression, un capteur optique, un capteur chimique, un biocapteur ou une biopuce.
